# EUROPEAN PATENT SPECIFICATION

(11) **EP 1 209 778 B1**
(45) Date of publication and mention of the grant of the patent: **06.10.2004**
(21) Application number: 02001129.2
(22) Date of filing: 17.07.2000
(51) Int. Cl.: H01R 43/20

(54) **A wire control apparatus and a wire mount control method**
Inspektionsapparat und Inspektionsverfahren für die Drahtmontage
Dispositif et méthode pour contrôler le montage de fils

(30) Priority: 28.07.1999 JP 21364899; 28.07.1999 JP 21364799
(43) Date of publication of application: 29.05.2002
(62) Divisional of application: 00114921.0
(73) Proprietor: Sumitomo Wiring Systems, Ltd., Yokkaichi-City, Mie, 510-8503 (JP)
(72) Inventor: Taniguchi, Yoshikazu, Sumitomo Wiring Systems Ltd., Yokkaichi-city, Mie, 510-8503 (JP); Taniguchi, Satoru, Kanazawa-City, Ishikawa, 921 (JP); Chiyoda, Kenji, Yokkaichi-city, Mie, 510-8503 (JP); Kato, Hajime, Yokkaichi-city, Mie, 510-8503 (JP)
(74) Representative: Müller-Boré & Partner Patentanwälte

(56) References cited:
- EP-A- 0 303 235
- EP-A- 0 715 173
- EP-A- 0 733 924
- EP-A- 0 901 204
- US-A- 5 410 115

## Description

The present invention relates to a wire mount control apparatus for controlling, in particular instructing and guiding proper mount positions of various wires in a desired connector formed with a plurality of insertion holes and preferably testing an electrical connection between the opposite ends of the wires. Furthermore, the invention relates to a wire mount control method.

### {First Prior Art}

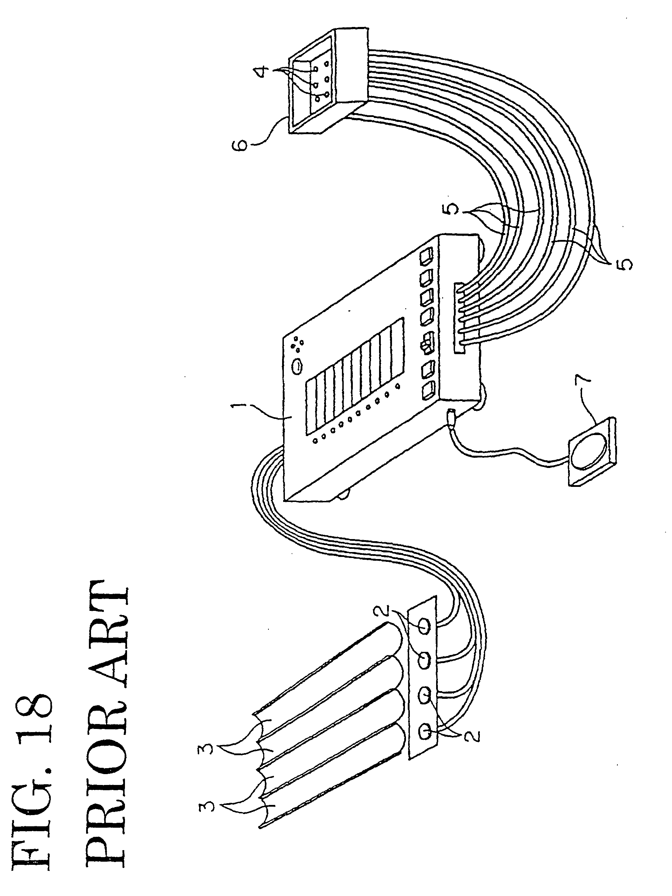

FIG. 18 shows a wire mount instructing/testing apparatus according to a first prior art. This apparatus is used when leading ends (one ends) of wires are mounted in one connector in a manufacturing process of a wiring harness or a subassembly thereof (wiring harness constructing part of a wiring harness), and adapted to substantially simultaneously instruct, guide and test proper insertion of the respective wires into the connector.

With this apparatus, the wires are mounted in a following procedure.

First, a connector (not shown) with which wires are to be connected is placed in a connector receptacle 6 shown in FIG. 18. Terminals for external connection are mounted in advance at ends of the wires to be connected with this connector, and the respective wires are accommodated in wire accommodating portions 3 corresponding to different kinds of the wires.

Next, one of instructing LEDs 2 is blinked to signal an operator by a command from a control unit 1 in accordance with a program of the control unit 1, and the operator takes a wire out from the wire accommodating portion 3 corresponding to the blinking instructing LED 2.

Then, one of a plurality of illuminating LEDs (not shown) provided in the control unit 1 is selectively turned on, and light emitted therefrom is guided to an other end 4 through an optical fiber 5 to illuminate one of the insertion holes of the connector (not shown) in the connector receptacle 6. The operator inserts the leading end (one end) of the wire taken out from the wire accommodating portion 3 in accordance with the blinking instructing LED 2 into the illuminated insertion hole of the connector for connection.

When the one end of the wire (A-end of the wire) is inserted into the insertion hole of the connector, the light reflected by the leading end of the terminal is guided to a light detector (not shown) in the control unit 1 through the optical fiber 5, and whether or not the terminal has been properly inserted is detected based on a signal of the light detector representing the received light. If the terminal has been properly inserted, a success buzzer (not shown) provided in the control unit 1 rings, and the blinking instructing LED 2 is turned off.

When the mounting of the first wire into the connector and the test are completed, a next wire to be taken out is instructed by blinking the corresponding LED 2, the insertion hole of the connector into which the taken wire is to be inserted is illuminated by the optical fiber 5, and whether or not the wire has been properly inserted is detected based on the presence or absence of the reflected light guided through the optical fiber 5. Hereafter, the mounting of the wires in the connector and the tests are successively performed in a similar manner.

Since the wire to be taken is instructed by blinking the corresponding instructing LED 2, the insertion hole of the connector into which the taken wire is to be inserted is illuminated by the optical fiber 5, and whether or not the wire has been properly inserted is detected based on the presence or absence of the reflected light guided through the optical fiber 5, the insertion of the terminal and the test on the inserted state can be simultaneously performed, thereby enabling an improvement in operation efficiency.

### {Second Prior Art}

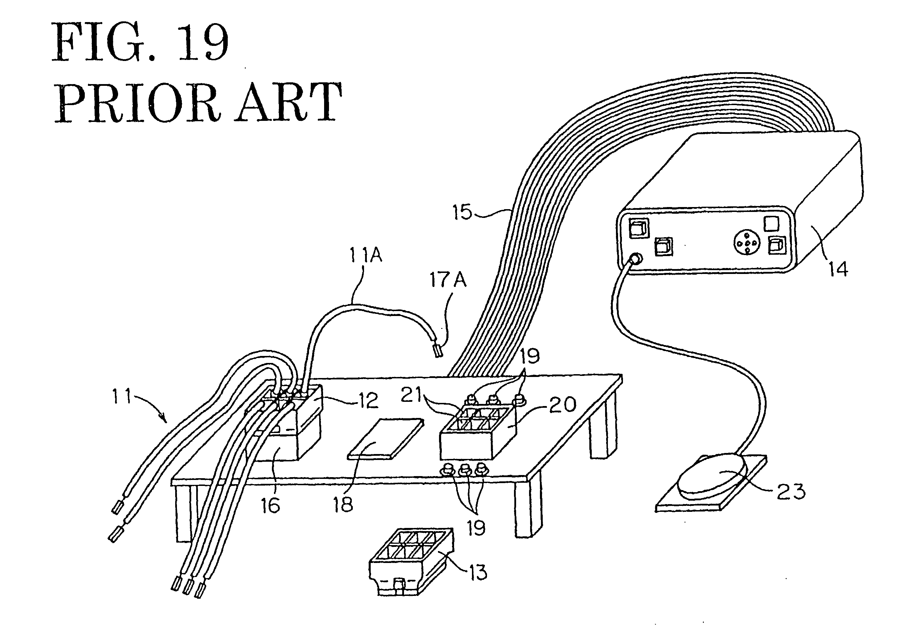

FIG. 19 shows a wire mount instructing/testing apparatus according to a second prior art. This apparatus is used when, with one ends of a plurality of wires 11 mounted in one connector (first connector) 12, the other ends of the wires 11 (B-ends of the wires) are mounted in proper positions of another connector (second connector) 13, and is adapted to substantially simultaneously instruct, guide and test proper insertion of the respective wires 11 into the second connector 13.

With this apparatus, the wires are mounted in a following procedure.

First, a specific voltage is applied from a specified circuit in a control unit 14 to all terminals (i.e. one ends of the wires 11) of the first connector 12 in which the wires 11 are mounted via a flexible printed-wiring strip 15 and specified electrodes (not shown) provided in a first connector receptacle 16.

Next, an operator selects a desired one (indicated by 11A in FIG. 19) of the plurality of wires 11 mounted in the first connector 12, and brings a terminal 17A at the other end of the selected wire 11A into contact with a ground plate 18. This ground plate 18 is grounded via the flexible printed-wiring strip 15 and the specified circuit in the control unit 14. Accordingly, a voltage level of the terminal in the first connector receptacle 16 connected with the one end of the wire 11A changes to LOW when the terminal 17A is brought into contact with the ground plate 18. By this change, a specified circuit in the control unit 14 specifies the wire 11A selected by the operator. Then, a specified circuit in the control unit 14 selects one of a plurality of illuminating LEDs 19 and applies a drive current thereto via the flexible printed-wiring strip 15 to turn it on.

A second connector receptacle 20 in which the second connector 13 is mounted is provided in vicinity of the plurality of illuminating LEDs 19, so that insertion positions of the respective wires 11 in the second connector 13 and the corresponding illuminating LEDs 19 are located adjacent to each other when the second connector 13 is mounted in the second connector receptacle 20. Accordingly, the operator mounts the terminal 17A at the other end of the selected wire 11A by inserting it into the corresponding insertion position of the second connector 13 adjacent to the illuminating LED 19 turned on when the specified circuit in the control unit 14 selects and causes one of the plurality of illuminating LEDs 19t to turn on. At this time, the terminal 17A is connected with a specified connector terminal (not shown) in the second connector 13 connected with the second connector receptacle 20.

At this stage, the respective unillustrated electrodes of the second connector receptacle 20 are connected with the terminal 17A at the other end of the wire 11A via the specified connector terminals in the second connector 13. When a voltage is applied to the respective electrodes of the second connector receptacle 20, it is outputted to the specified circuit in the control unit 14 via the flexible printed-wiring strip 15. Accordingly, the voltage is applied from the control unit 14 to the one end of the wire 11A via the flexible printed-wiring strip 15 and the electrodes provided in the first connector receptacle 16. Electrical connections between the respective electrodes in the first connector receptacle 16 and those in the second connector receptacle 20 can be tested by inputting the voltage from the terminal 17A at the other end of the wire 11A to the control unit 14 via the connector terminals in the second connector 13, the electrodes of the second connector receptacle 20 and the flexible printed-wiring strip 15. As a result, whether or not the wire 11A is mounted in the proper mount position of the connector can be detected.

For the other wires 11 mounted in the first connector 12, the mounting in the second connector 13 is instructed and whether or not the wire is mounted in a proper mount position is detected in a similar manner.

Identified by 7 and 23 in FIGS. 18 and 19, respectively, are pedal switches (automatic/manual operation instructing means) for instructing an manual operation so that the operator can manually input an actual operation relating to the wire insertion and guide and register a product number of the wires.

In the first prior art, the wire mount position is instructed and guided and the mounting of the wire is tested for the end (one end: hereinafter, "A-end") of the wire to be first connected with the connector. On the contrary, in the second prior art, the proper wire mount position is instructed and guided and the mounting of the wire is tested for the other end (hereinafter, "B-end") of the wire having the one end thereof already connected with the connector. These operations are desirably performed by a flow production.

However, since the first and second prior arts are realized as separate wire mount instructing/testing apparatuses as shown in FIGS. 18 and 19, it is difficult to perform the above operations by a flow production at the same operation site. Thus, an assembly of one connector and the respective wires having one ends thereof connected with one connector by the apparatus shown in FIG. 18 has to be transferred to the apparatus shown in FIG. 19 to have the other ends of the respective wires connected with an other connector. Such a combination of the operations provides no optimal operation efficiency.

It is possible to commonly use part of elements of the apparatuses shown in FIGS. 18 and 19. For instance, it is possible to provide the control unit 1 shown in FIG. 18 with the function of the control unit 14 shown in FIG. 19, to switch the functions by specifically switching a mode, to commonly use the connector receptacle 6 shown in FIG. 18 and the connector receptacles 16, 20 shown in FIG. 19, and to commonly use the pedal switches 7, 23. However, even with such a rearrangement, it has been difficult to improve a time efficiency since the operation described with respect to the first prior art and the one described with respect to the second prior art need to be performed in a time sequence.

In the aforementioned first and second prior arts, whether or not the ends of the wires have been mounted in proper mount positions is tested by, after connecting the connectors (12, 13 in FIG. 19) with the connector receptacles 6, 16, 21, inserting the ends of the wires into the respective cavities (insertion holes) of the connectors and detecting electrical connections between the wires and the connectors. However, if the connector receptacles 6, 16, 20 compatible with the respective connectors actually used in the subassembly are used one by one, the connector receptacles 6, 16,20 themselves have to be changed when the product number of the subassembly is changed, which presents a poor (atode). In view of this, it is desirable to use a wire insertion detecting jig having a good (atode) which can cope with product numbers of all subassemblies.

In the case of using such wire insertion detecting jigs having a good (atode), wirings for the connection between the wire insertion detecting jigs and the control units 1, 14 increase in proportion to the maximum number of the wires to be assembled since these detecting jigs need to cope with assembling of many wires. As a result, a large space is required for the wirings for connection, presenting a difficulty in layout of wirings. Particularly, in the case of the second prior art relating to the mounting of the B-ends, it is necessary to consider not only detection of mounting of the wires, but also a wiring for the ground plate 18. Therefore, there is a demand for an improvement in wiring efficiency.

EP 0 733 924 discloses a cable arrangement indicating and inspecting apparatus for a connector. Cables are removed from cable receiving portions in accordance with indicator LEDs caused to blink by a first driving portion, and light from illuminative LEDs turned on by a second driving portion is directed through light emitting optical fibers and detecting optical fibers into receiving holes of a connector to directly illuminate the interior of select receiving holes into which terminals are to be inserted. When the terminals are inserted into the select receiving holes, the light reflected from the terminals is directed through the detecting optical fibers and light receiving optical fibers onto light receiving portions, and proper terminal insertion is detected on the basis of a light reception signal from the light receiving portions.

An object of the present invention is to provide a wire mount control apparatus and method allowing to efficiently control or instruct in which mount positions of connectors opposite ends of wires forming a wiring harness should be mounted and preferably test the mounting of the wires at a single operation site.

This object is solved by a wire mount control apparatus according to claim 1 and by a wire mount control method according to claim 13. Preferred embodiments of the invention are subject of the dependent claims.

According to the invention, there is provided a wire mount control apparatus for controlling the mounting or assembling of wires in a desired connector formed with a plurality of insertion holes, comprising:
a plurality of wire supplying means for supplying or accommodating various wires to be supplied,
instructing indicators or lamps or displays provided in a preferably one-on-one correspondence with the plurality of wire supplying means for instructing or indicating one wire supplying means supplying or accommodating a wire to be taken or grasped by an operator,
a plurality of wire insertion detecting jigs for at least partly accommodating desired connectors to be connected with specified wires and detecting whether or not the respective wires have been inserted into the plurality of insertion holes of the connectors, and
a control means for electrically controlling the instructing indicators and the wire insertion detecting jigs,
wherein:
each wire insertion detecting jig comprises a jig main body formed with an accommodation portion into which the connector is at least partly mountable, one or more probes, in particular according to the invention or an embodiment thereof, which are preferably so provided in the accommodation portion of the jig main body as to substantially correspond to the respective insertion holes of the connector, and which are held at a specified first potential when an end of the wire is not inserted in the corresponding insertion hole while having its potential switched to a second potential different from the first potential when the end of the wire is inserted into the corresponding hole to contact the probe, guiding indicators or lamps or displays provided in preferably one-on-one correspondence with the probes for indicating the insertion hole of the connector into which the operator should mount the wire, and
the control means comprises:
   a first indicating section for indicating one wire supplying means supplying the wire the operator should take by controlling a corresponding one of the instructing indicators for each of the wires in accordance with an assembling order based on a specified information preferably registered in advance in a specified storage means, indicating a proper single insertion hole of the connector in which the operator should mount the one end of each wire by controlling the guiding indicator corresponding to the proper insertion hole,
   a second indicating section for detecting a wire chosen by the operator in order to mount the other end of each wire in an other connector accommodated in an other wire insertion detecting jig with the one end of each wire mounted in one connector accommodated in the one wire insertion detecting jig, indicating a proper single insertion hole of the other connector in which the operator should mount the other end of each wire by controlling the guiding indicator corresponding to the proper insertion hole based on the detection result and a specified information preferably registered in advance in the specified storage means.

According to a preferred embodiment of the invention, the wire insertion detection jig comprises a touch plate or portion which is exposed on the outer surface of the jig main body such that the operator can intentionally bring the end of the wire into contact with the touch plate, and is held at the first potential.

Preferably, the second indicating section detects the wire chosen by the operator by means of the contact of the other end of each wire with the touch plate based on a change in the voltage level of the probe in contact with the one end of each wire from the second potential to the first potential when the operator brings the other end of each wire into contact with the touch plate held at the first potential.

Further preferably, the first instructing section is provided also for judging that the one end of each wire has been properly mounted when the voltage level of the probe located at the mount position is switched from the first potential to the second potential.

Still further preferably, the second instructing section is provided also for judging that the other end of each wire has been properly mounted when the voltage level of the probe located at the mount position is switched from the first potential to the second potential.

Most preferably, the control means further comprises an electrical connection testing section for testing an electrical connection between the one connector and the other connector through detection of potential changes in the probe of the one wire insertion detecting jig and the corresponding probe of the other wire insertion detecting jig by successively switching either the potentials of the respective probes in the one wire insertion detecting jig or those of the respective probes in the other wire insertion detecting jig from the first potential to the second potential preferably after the indication and/or the judgment are completed for all the wires in the first and second indicating sections.

According to a further preferred embodiment of the invention, there is provided a wire mount instructing/testing apparatus as a wire mount control apparatus for instructing and guiding various wires to be assembled and proper mount positions of the various wires in a desired connector formed with a plurality of insertion holes, and testing an electrical connection of the opposite ends of the respective wires, comprising:
a wire supplying means having a plurality of supplying channels for accommodating various wires to be supplied,
instructing lamps provided in one-on-one correspondence with the plurality of supplying channels for instructing one supplying channel accommodating a wire to be taken out by an operator,
a plurality of wire insertion detecting jigs for accommodating desired connectors to be connected with specified wires and detecting whether or not the respective wires have been inserted into the plurality of insertion holes of the connectors, and
a control means for electrically controlling the instructing lamps and the wire insertion detecting jigs,
wherein:
each wire insertion detecting jig comprises a jig main body formed with an opening into which the connector is mounted, probes which are so provided at the bottom of the opening of the jig main body as to correspond to the respective insertion holes of the connector and are held at a specified first potential when an end of the wire is not inserted in the corresponding insertion hole while having its potential switched to a second potential different from the first potential when the end of the wire is inserted into the corresponding hole to contact the probe, guiding lamps provided in one-on-one correspondence with the probes for guiding the insertion hole of the connector into the opening into which the operator should mount the wire, and a touch plate which is exposed on the outer surface of the jig main body such that the operator can intentionally bring the end of the wire into contact with the touch plate, and is held at the first potential, and
the control means comprises:
   a first instructing/guiding (indicating) section for instructing one supplying channel accommodating the wire the operator should take out by drivingly turning on a corresponding one of the instructing lamps for each of the wires in accordance with an assembling order based on a specified information registered in advance in a specified storage means, guiding a proper single insertion hole of the connector in which the operator should mount the one end of each wire by drivingly turning on the guiding lamp corresponding to the proper insertion hole, and judging that the one end of each wire has been properly mounted when the voltage level of the probe located at the mount position is switched from the first potential to the second potential,
   a second instructing/guiding (indicating) section for detecting the contact of the other end of each wire with the touch plate based on a change in the voltage level of the probe in contact with the one end of each wire from the second potential to the first potential when the operator brings the other end of each wire into contact with the touch plate held at the first potential in order to mount the other end of each wire in an other connector accommodated in an other wire insertion detecting jig with the one end of each wire mounted in one connector accommodated in the one wire insertion detecting jig, guiding a proper single insertion hole of the other connector in which the operator should mount the other end of each wire by drivingly turning on the guiding lamp corresponding to the proper insertion hole based on the detection result and a specified information registered in advance in the specified storage means, and judging that the other end of each wire has been properly mounted when the voltage level of the probe located at the mount position is switched from the first potential to the second potential, and
   an electrical connection testing section for testing an electrical connection between the one connector and the other connector through detection of potential changes in the probe of the one wire insertion detecting jig and the corresponding probe of the other wire insertion detecting jig by successively switching either the potentials of the respective probes in the one wire insertion detecting jig or those of the respective probes in the other wire insertion detecting jig from the first potential to the second potential after the guiding and the judgment are completed for all the wires in the first and second instructing/guiding sections.

Accordingly, when the operator is to mount one end of each wire into one connector mounted in one wire insertion detecting jig, the first instructing/guiding (indicating) section instructs one wire supplying means or supplying channel supplying or accommodating the wire the operator should take out by drivingly turning on a corresponding one of the instructing lamps for each of the wires in accordance with the assembling order based on the specified information registered in advance in the specified storage means, guides the proper single insertion hole of the connector in which the operator should mount the one end of each wire by drivingly turning on the guiding lamp corresponding to the proper insertion hole, and judges that the one end of each wire has been properly mounted when the voltage level of the probe located at the mount position is switched from the first potential to the second potential. When the operator is to mount the other end of each wire into an other connector mounted in an other insertion detecting jig with the one ends of the respective wires mounted in the one connector mounted in the one wire insertion detecting jig, the second instructing/guiding (indicating) section detects the contact of the other end of each wire with the touch plate based on a change in the voltage level of the probe in contact with the one end of each wire from the second potential to the first potential when the operator brings the other end of each wire into contact with the touch plate held at the first potential in order to mount the other end of each wire in an other connector accommodated, guides a proper single insertion hole of the other connector in which the operator should mount the other end of each wire by drivingly turning on the guiding lamp corresponding to the proper insertion hole based on the detection result and the specified information registered in advance in the specified storage means, and judges that the other end of each wire has been properly mounted when the voltage level of the probe located at the mount position is switched from the first potential to the second potential. The electrical connection testing section tests an electrical connection between the one connector and the other connector after the guiding and the judgment are completed for all the wires in the first and second instructing/guiding (indicating) sections. Accordingly, the connection of the wires with the connectors can be efficiently recognized by the operator and, if he tries to insert the wire in a mistaken manner, the control means can immediately detect it. Particularly, since the process of mounting the other ends of the wires into the other connector is started when the operator brings the other end of one wire into contact with the touch plate at an arbitrary timing, such a process can be performed in any operation sequence. Thus, in the case of, e.g. assembling a plurality of wires by mounting them into a specified tube, all the other ends of the wires may be mounted in the other connector after the one ends thereof are mounted in the one connector. Alternatively, the wires may be mounted one by one such as in a case where the opposite ends of a next wire may be connected with two connectors after those of a first wire are connected with the two connectors. This provides an advantage that the operator can conduct an actual assembling operation in accordance with the operation sequence he freely selects. Further, the electrical connection tests for all the wires can be conducted after all the wires are mounted. Therefore, operation efficiency can be significantly improved as compared with the conventional practice with which the one ends and the other ends of the wires are mounted into the respective connectors by separate apparatuses.

Preferably, the apparatus further comprises a sound output means for notifying a success in tests by a specified sound if the first instructing/guiding or indicating section judges that the one end of each wire has been properly mounted, the second instructing/guiding or indicating section judges that the other end of each wire has been properly mounted and/or the electrical connection testing section detects the proper electrical connection based on an information in the storage means, while notifying a failure in tests by a specified sound if the first instructing/guiding or indicating section judges that the one end of each wire has not been properly mounted, the second instructing/guiding or indicating section judges that the other end of each wire has not been properly mounted and/or the electrical connection testing section does not detect the proper electrical connection based on the information in the storage means.

Accordingly, a success or failure in mounting the wires can be easily notified to the operator by sounds.

Further preferably, the apparatus further comprises a combination selecting/designating means for selecting and designating one of a plurality of combinations of the wire mount positions for each connector, wherein the controller further comprises a data registering unit for registering data on the plurality of combinations of the wire mount positions for each connector.

Accordingly, the operator can mount the wires in accordance with various specifications using the same wire mount instructing/testing apparatus by registering a plurality of specifications beforehand.

Most preferably, the control means instructs or indicates one wire supplying means supplying the wire the operator should take out by controlling (or activating or changing a state of), preferably by blinking one of the instructing indicators or lamps based on the information in the storage means if the operation of the first instructing/guiding or indicating section starts with none of all the probes of all the wire insertion detecting jigs contacted by the wire, and controls (or activates or changes a state of), preferably turns on all the instructing indicators or lamps corresponding to all the wire supplying means or supplying channels supplying or accommodating the wires to be mounted into the one connector later based on the selected and designated content of the selecting/designating means and/or the information in the storage means.

Accordingly, the instructing indicator or lamp corresponding to the wire to be connected with the one connector is blinked and the one corresponding to the wire to be connected next with this connector is preferably turned on. It is convenient because the operator can easily know succeeding operations.

According to a further preferred embodiment, the second instructing/guiding or indicating section of the control means judges that the other end of each wire has been properly mounted when the voltage level of the probe located at the correct single insertion hole of the other connector is switched from the first potential to the second potential without the other end of each wire being brought into contact with the touch plate by the operator.

Accordingly, the second instructing/guiding or instructing section judges that the other end of each wire has been properly mounted also when the voltage level of the probe located at the correct single insertion hole of the other connector is switched from the first potential to the second potential without the other end of each wire being brought into contact with the touch plate by the operator. Accordingly, the operator can save labor to illuminate the guiding lamps by bringing the other end of each wire into contact with the touch plate, for example, in the case of repeatedly forming (sub)assemblies of the same specification, with the result that operation efficiency can be improved.

Preferably, the control means is formed with at least one success output terminal for outputting a success signal if all the wires have been properly mounted in the connectors accommodated in the one and other wire insertion detecting jigs, and the control means is preferably constructed to receive a success signal sent from a success output terminal of an other wire mount instructing/testing or control apparatus and, in such a case, outputs the success signal from the success output terminal thereof only when all the wires relating to this control means have been properly mounted and the success signal is inputted from the other wire mount instructing/testing or control apparatus.

Accordingly, by connecting a plurality of wire mount instructing/testing or control apparatuses using the success output terminals, the connection of the number of wires which cannot be handled by one wire mount instructing/testing or control apparatus can be guided and tested using the plurality of wire mount instructing/testing or control apparatuses.

Most preferably, the control means comprises:
a function of switchingly setting a data registration mode for registering or storing or detecting an assembling order of the respective wires and a correspondence between one ends and other ends of the respective wires based on a specified operation of the operator,
a function of, with the data registration mode set, registering sequences of the controlled or activated or turned-on state or blinking state of the respective instructing indicators or lamps and/or the respective guiding indicators or lamps and a sequence of bringing the one ends of the plurality wires into contact with the respective probes when the operator brings the one ends of the respective wires into contact with the respective probes in the one wire insertion detecting jig in a sequence employed in an actual operation while corresponding the controlling or activating or turning-on or blinking of the respective instructing lamps or indicators and/or the respective guiding lamps or indicators, and/or
a function of, when connectors of a specified model harness completed beforehand by mounting opposite ends of wires in connectors are mounted in the respective wire insertion detecting jigs with the data registration mode set, extracting a correspondence in connection of the opposite ends of the respective wires mounted in the connectors and saving it in the storage means.

Accordingly, the correct operation confirming to an actual operation is registered as data by the operator bringing the one ends of a plurality of wires into contact with the respective probes in one wire insertion detecting jig in an operation sequence employed by the actual operation with the data registration mode set. Accordingly, the data can be registered by a very simple method, and anybody can easily carry out data registration. Further, since the operation procedure during the data registration is the same as the one employed during the actual operation (of instructing and guiding insertion), there is an advantage that the operator can easily recognize the operation procedure at the same time he carries out the data registration.

Further, when the connectors of the specified model harness completed beforehand in which the opposite ends of the respective wires are mounted in the respective connectors are mounted into the respective wire insertion detecting jigs, a correspondence in connection between the opposite ends of the respective wires mounted in the connectors is extracted and registered in the storage means. Thus, data can be automatically registered only by mounting the connectors of the model harness prepared beforehand into the wire insertion detecting jigs. Therefore, data registration can be carried out by a very easy operation.

According to the invention, there is further provided a wire mount control method for controlling the mounting of wires in a desired connector formed with a plurality of insertion holes, comprising the steps of:
accommodating various wires to be supplied in a plurality of wire supplying means,
providing instructing indicators in a preferably one-on-one correspondence with the plurality of wire supplying means for instructing or indicating one supplying channel accommodating a wire to be taken or grasped by an operator,
providing guiding indicators in a preferably one-on-one correspondence with the probes for indicating the insertion hole of the connector into which the operator should mount the wire,
at least partly accommodating desired connectors to be connected with specified wires in a plurality of wire insertion detecting jigs, the wire insertion detecting jigs being suitable to detect whether or not the respective wires have been inserted into the plurality of insertion holes of the connectors, wherein, when a portion of one wire is not inserted into the respective insertion hole of the connector, a probe provided in the wire insertion detecting jig in a position corresponding to the insertion hole is held at a specified first potential while having its potential switched to a second potential different from the first potential when the end of the wire is inserted into the corresponding hole to contact the probe, and
electrically controlling the instructing indicators and the wire insertion detecting jigs by means of a control means,
indicating by means of a first indicating section one wire supplying means supplying the wire the operator should take by controlling a corresponding one of the instructing indicators for each of the wires in accordance with an assembling order based on a specified information preferably registered in advance in a specified storage means, indicating a proper single insertion hole of the connector in which the operator should mount the one end of each wire by controlling the guiding indicator corresponding to the proper insertion hole,
detecting by means of a second indicating section a wire chosen by the operator in order to mount the other end of each wire in an other connector accommodated in an other wire insertion detecting jig with the one end of each wire mounted in one connector accommodated in the one wire insertion detecting jig, and
indicating a proper single insertion hole of the other connector in which the operator should mount the other end of each wire by controlling the guiding indicator corresponding to the proper insertion hole based on the detection result of the second indicating section and a specified information preferably registered in advance in the specified storage means.

These and other objects, features and advantages of the present invention will become apparent upon a reading of the following detailed description and accompanying drawings in which:
FIG. 1 is a perspective view showing the external configuration of a wire mount instructing/testing apparatus according to one embodiment of the invention,
FIG. 2 is a circuit diagram schematically showing the entire wire mount instructing/testing apparatus,
FIG. 3 is a perspective view of a wire insertion detecting jig used in the wire mount instructing/testing apparatus,
FIG. 4 is a section of the wire insertion detecting jig used in the wire mount instructing/testing apparatus,
FIG. 5A is a section of a probe in the wire insertion detecting jig used in the wire mount instructing/testing apparatus,
FIG. 5B is an enlarged section showing a natural state of the probe used in the wire insertion detecting jig,
FIG. 5C is an enlarged section showing a wire-inserted state of the probe used in the wire insertion detecting jig,
FIG. 6 is a perspective view showing a front surface of a control unit used in the wire mount instructing/testing apparatus,
FIG. 7 is a perspective view showing a rear surface of the control unit used in the wire mount instructing/testing apparatus,
FIG. 8 is a block diagram showing functions of a CPU in the control unit used in the wire mount instructing/testing apparatus,
FIG. 9 is a perspective view of a product number switching board used in the wire mount instructing/testing apparatus,
FIG. 10 is a perspective view of a flat cable for connecting the product number switching board and the control unit,
FIG. 11 is a diagram showing the rear surfaces of the control units when a plurality of wire mount instructing/testing apparatuses are used in combination,
FIG. 12 is a diagram showing a model harness used for the embodiment of the invention,
FIG. 13 is a timing chart showing an operation of the wire mount instructing/testing apparatus,
FIGS. 14 to 17 are a flow chart showing an operation procedure of wire mount instructing/testing apparatus,
FIG. 18 is a diagram showing a wire mount instructing/testing apparatus according to first prior art, and
FIG. 19 is a diagram showing a wire mount instructing/testing apparatus according to second prior art.

### <Construction>

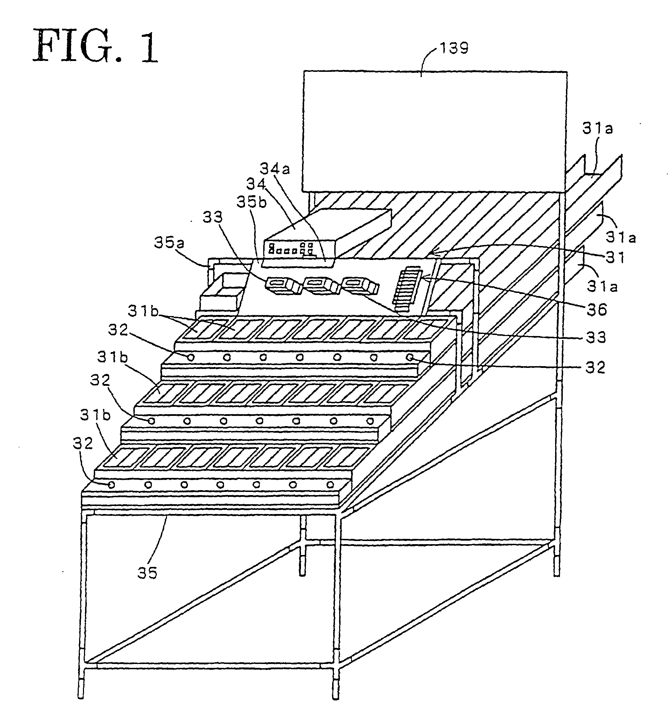

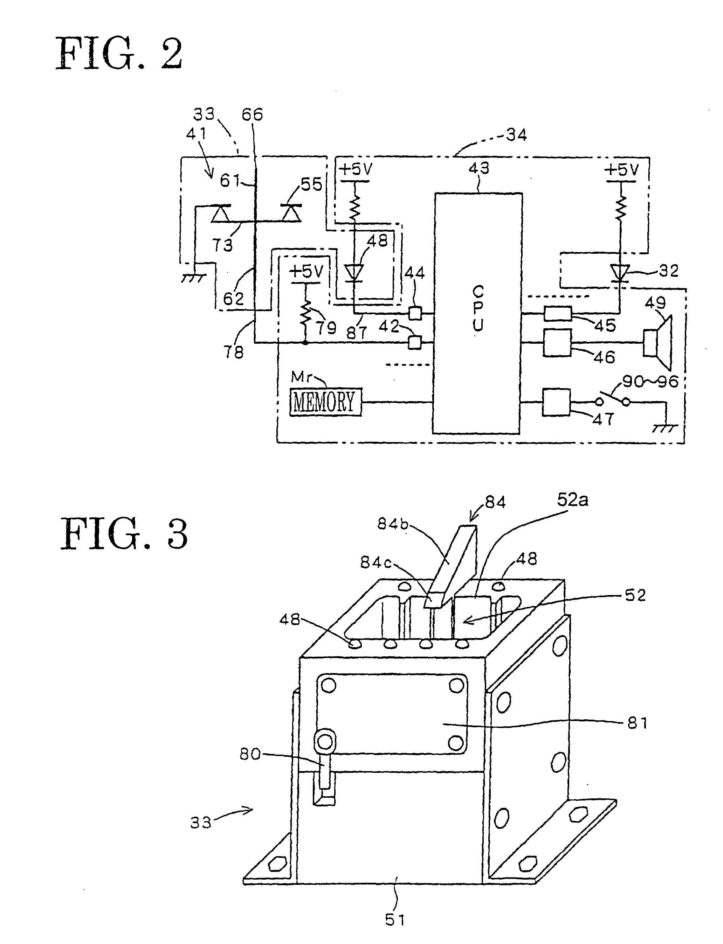

FIG. 1 is a perspective view showing the external configuration of a wire mount instructing/testing apparatus according to one embodiment of the invention comprising a wire insertion detection jig according to a preferred embodiment of the invention, and FIG. 2 is a block diagram schematically showing the embodiment.

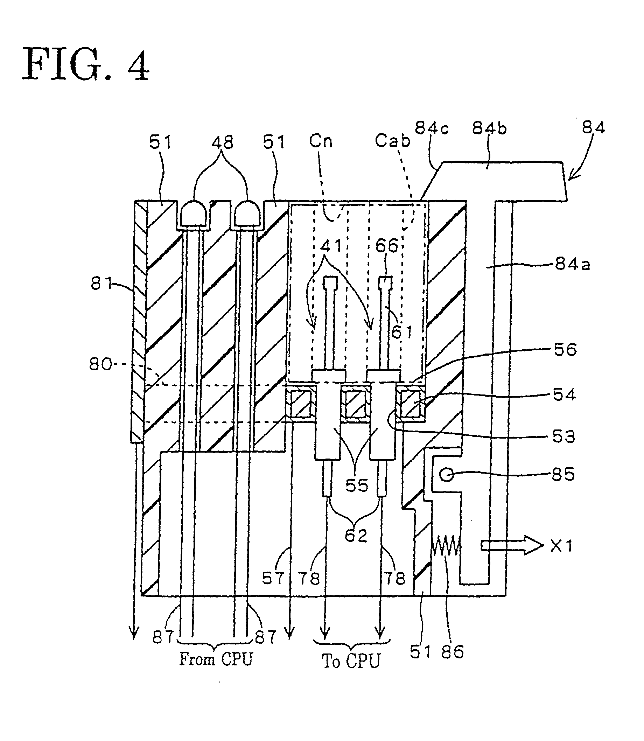

This apparatus is designed to enable controlling e.g. instructing, guiding and/or testing of proper mount positions of opposite ends of wires forming a subassembly in corresponding connectors in a single apparatus and also enable detection of an electrical connection between the opposite ends of each wire in a manufacturing process or the like of a subassembly harness (partial wiring harness which forms part of the wiring harness) of a wiring. As shown in FIG. 1, this apparatus is provided with a wire supplying unit (wire supplying means) 31, instructing LEDs (instructing lamps or indicators or displays or panel) 32, a plurality of wire insertion detecting jigs 33, a control unit (control means) 34, a specified work table 35, and a product number switching board (combination selection instructing means) 36. The elements 31, 32, 33, 34 and 36 are or can be placed or arranged on the work table 35 to form or be comprised in an apparatus unit. The wire supplying unit 31 includes a plurality of supplying channels 31a which are substantially placed at least partly above or transversely next to each other for separately accommodating a plurality of wires of different kinds so that the wires substantially extend in a longitudinal direction thereof or from the back side to the front side in FIG. 1. Alternatively or additionally to the supplying channels 31a the wire supplying means may comprise one or more racks or holders as wire holding means for holding or supplying one or more wires to be taken or grasped by the operator. The instructing LEDs 32 are preferably provided in one-on-one correspondence with the supplying channels 31a. Alternatively or additionally one instructing means or indicator may be provided for two or more supplying channels 31a and may have different colors and/or shapes for identifying a specific (predetermined or predeterminable) supplying channel 31a. A connector (see Cn in FIG. 4) with which wires are connected is placed in each detecting jig 33, which in turn detects whether or not the respective wires have been properly mounted into insertion holes (cavities) (see Cab in FIG. 4) of the connector Cn. The control unit 34 electrically controls the elements 31, 32 and 33. The switching board 36 enables a product number of the subassembly to be switched by actuating a switching means, e.g. by pushing a button.

In the wire supplying unit 31, a plurality of supplying channels 31a are preferably inclined downward toward their front sides or a dispensing side, so that wires placed at the back sides of the respective supplying channels 31a slide down to the front side thereof to substantially come into contact with end walls 31c. The leading ends of the wires in contact with the end walls 31c can be taken out through discharge or upper openings 31b formed in the upper surfaces of the supplying channels 31a. In vicinity of the respective upper openings 31b, the instructing LEDs 32 are provided in one-on-one correspondence with the upper openings 31b.

The instructing/testing apparatus is constructed such that whether or not the wires are mounted in the respective cavities (Cab in FIG. 4) of the connector Cn placed in the wire insertion detecting jig 33 is detected by inputting voltage levels or currents or signals of later described probes 41 provided in the wire insertion detecting jig 33 to the control unit 34 and feeding changes in such voltage levels to a CPU 43 via a detection signal input/output circuit 42 in the control unit 34. The CPU 43 in the control unit 34 drives later described guiding LEDs or displays or indicators (point guides) 48 provided in or on or at the wire insertion detecting jigs 33, the instructing LEDs 32 corresponding to the respective supplying channels 31a and a buzzer (sound output means) 49 provided in the contro! unit 34 by controllably driving various driving circuits 44, 45, 46.

Examples of the wire insertion detecting jig 33 are shown in perspective in FIG. 3 and in section in FIG. 4. Unlike the construction of FIG. 3 in which the guiding LEDs 48 are aligned in a line around an opening 52a of an accommodation portion 52 for at least partly accommodating a connector Cn, two lines of the guiding LEDs 48 are arranged at the left side of the opening in the construction of FIG. 4. The jig 33 can take any layout provided that the guiding LEDs 48 are provided in easily understandable correspondence with the probes 41 in the opening 52a.

A plurality of wire insertion detecting jigs 33 are provided on a fixed plate 35b (see FIG. 1) placed above the wire supplying units 31 using a frame or support 35a secured to the work table 35. The plurality of wire insertion detecting jigs are provided because, after one ends ("A-ends") of wires are connected with a connector Cn (see FIG. 4) mounted in one wire insertion detecting jig 33, the other ends ("B-end") thereof are connected with a connector Cn (see FIG. 4) mounted in an other wire insertion detecting jig 33. Depending upon the product number of the subassembly, the one end of a certain wire may be connected with an other connector different from the above, i.e. the wires may require three (different) connectors, it is desirable to provide three wire insertion detecting jigs 33 on the fixed plate 35b in view of such a possibility.

Each wire insertion detecting jig 33 is basically constructed such that the accommodating portion 52 for at least partly accommodating the connector Cn is formed in the upper surface of a jig main body 51 as shown in FIGS. 3 and 4. A base plate 54 formed with one or more through holes 53 are secured to the bottom of the opening 52a, and a corresponding number, preferably a plurality of probes 41 are or can be fitted or inserted into the through holes 53 as shown in FIG. 4. These probes 41 are so provided as to substantially correspond to mount positions (the respective cavities Cab) of the wires into the connector Cn, so that, when one wire is mounted into any one of the cavities Cab of the connector Cn, the leading end of the wire comes into contact with the upper end (leading end head 66) of the probe 41. A metal plating 56 of, e.g. tin preferably having an excellent conductivity is applied to the entire upper and lower surfaces of the base plate 54 and the entire inner surfaces of the through holes 53 of the base plate 54 where the probes 41 are fitted, such that the metal plating 56 can be held in close contact with conductive barrels 55 at the outer peripheries of the probes 41. The metal plating 56 is grounded via a specified ground lead wire 57. Thus, the barrels 55 of the probes 41 are constantly held at ground potential. More in particular, the metal plating 56 is commonly connected with all the probes 41 and is grounded via one ground lead wire 57, so that the barrels 55 of all the probes 41 can be held at ground potential only by using the single ground lead wire 57.

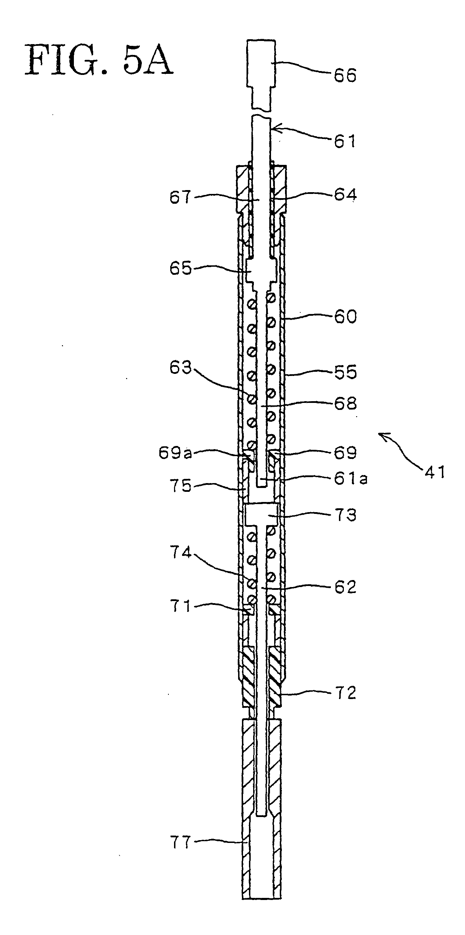

The construction of each probe 41 is shown in FIGS. 5A to 5C. As shown in FIG. 5A, the probe 41 is constructed such that a substantially bar-shaped plunger 61 is loosely fitted into a top side of a through hole 60 inside the barrel 55 made of a metal material in such a manner as to project upward or toward the wires to be inserted into the cavities Cab, and a substantially bar-shaped rod 62 is loosely fitted into a bottom side of the through hole 60.

An upper bar 67 which is an upper half of the plunger 61 is loosely fitted into a tubular stopper 64 made of an electrically insulating material such as resin and secured to the upper end of the inner surface of the through hole 60 of the barrel 55, and a lower bar 68 which is a lower half of the plunger 61 is loosely fitted into a substantially tubular guiding tube 69 made of an electrically insulating material such as resin and secured to a middle portion of the inner surface of the through hole 60 of the barrel 55. Accordingly, the plunger 61 is loosely movable along a longitudinal, preferably substantially vertical direction in the upper half of the through hole 60 without establishing any electrical contact with the barrel 55. A spring bearing portion 65 bulges radially outward in a middle position of the plunger 61, and is biased upward by a biasing member 63 such as a coil spring supported on a flange 69a of the guiding tube 69 secured in the barrel 55. By a biasing force of the biasing member 63, the spring bearing portion 65 of the plunger 61 is held in contact with the bottom end of the electrically insulating tubular stopper 64 secured to the upper end of the barrel 55 in its natural state. Thus, the upper bar 67 of the plunger 61 is so held as to at least partly project from the upper end of the barrel 55 at least as long as the leading end head 66 formed at the upper end of the plunger 61 is not pushed down by the wire.

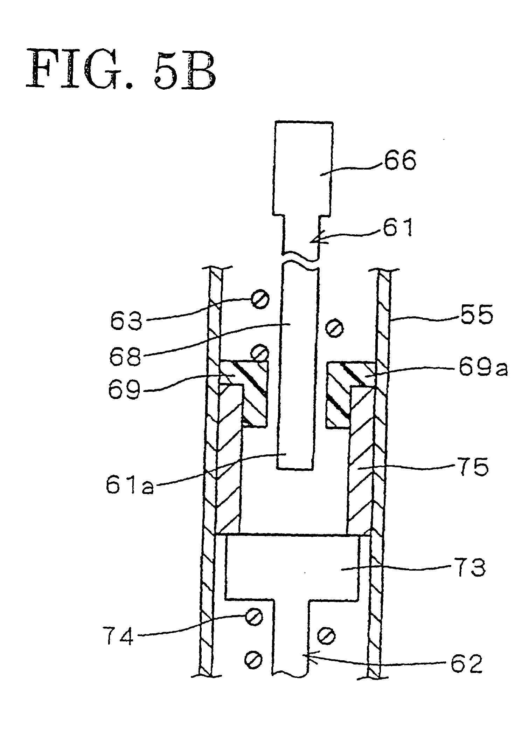

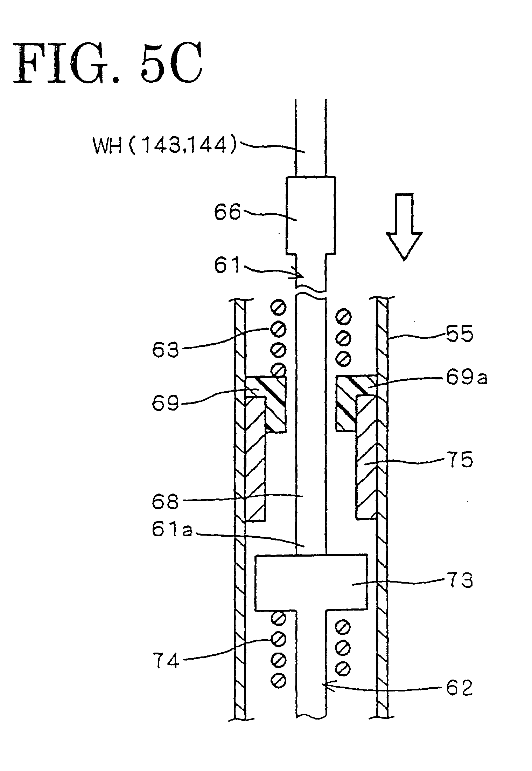

The rod 62 is loosely fitted into ring-shaped insulating collars 71, 72 made of an electrically insulating material such as resin and secured to a bottom part of the inner surface of the through hole 60 of the barrel 55. Accordingly, the rod 62 is loosely movable along vertical direction in the lower half of the through hole 60 without establishing any electrical contact with the barrel 55. A spring bearing portion 73 bulges radially outward at the upper end of the rod 62, and is biased upward by a biasing member 74 such as a coil spring supported on the upper insulating collar 71. By a biasing force of the biasing member 74, the spring bearing portion 73 of the rod 62 is disengageably held in contact with the bottom end of a conductive tubular or ring-shaped contact element (stopper 75) electrically connected with and secured to the inner surface of the barrel 55 in its natural state as shown in FIG. 5B. Thus, the rod 62 is held electrically connected with the barrel 55 via the contact element (stopper) 75 as shown in FIG. 5B as long as the spring bearing portion 73 of the rod 62 is not pushed down by a bottom end 61 a of the plunger 61 (see FIG. 5C). Identified by 77 in FIG. 5A is a connecting tube for connecting the bottom end of the rod 62 to a lead wire (see 78 in FIG. 4) for external connection by soldering or the like. This connecting tube 77 is held electrically disconnected from the barrel 55 by being secured only to the bottom end of the insulating collar 72 projecting downward from the barrel 55.

In a natural state of the probe 41 constructed as above, the spring bearing portion 65 of the plunger 61 is biased upward by the biasing member 63, keeping the rod 62 located below the plunger 61 in its natural state as shown in FIG. 5B, which causes the spring bearing portion 73 of the rod 62 to be biased upward by the biasing member 74, causing the rod 62 to come into contact with the conductive contact element 75 to be held at a ground potential (first potential) of the barrel 55. On the other hand, when an end of a wire (A-end or B-end: see WH in FIG. 5C) is mounted into the cavity Cab of the connector Cn to push the leading end head 66 of the plunger 61 of the probe 41 down in the opening 52a formed in the upper surface of the wire insertion detecting jig 33, the spring bearing portion 73 of the rod 62 is pushed down by the bottom end 61a of the plunger 61, with the result that the rod 62 is disengaged from the contact element 75 to thereby cancel an electrical connection between the rod 62 and the barrel 55. As shown in FIG. 2, the bottom end of the rod 62 of the probe 41 is connected to a pull-up resistor 79 via the lead wire 78 for external connection, and a point of connection with the pull-up resistor 79 is connected to the CPU 43 via the detection signal input/output circuit 42. By this construction, as long as the wire does not come into contact with the leading end head 66 of each respective probe 41, the probe 41 is held in its natural state and at the ground potential of the barrel 55 and a signal inputted to the CPU 43 via the detection signal input/output circuit 42 is a LOW signal. On the other hand, when the wire comes into contact with the leading end head 66 of each respective probe 41, the electrical connection of the probe 41 with the grounded barrel 55 is canceled, with the result that a signal inputted to the CPU 43 via the detection signal input/output circuit 42 becomes a HIGH signal.

A touch plate 81 to be connected with the metal plating 56 and the ground lead wire 57 of the base plate 54 via a connecting piece 80 is provided on one side surface of each wire insertion detecting jig 33 as shown in FIGS. 3 and 4. An operator can lower a voltage of the wire to a ground (LOW) potential (first potential or state) any time by bringing an end of the wire into contact with the touch plate 81. Accordingly, the voltage level of the entire wire can be lowered from HIGH to LOW (first potential or state) any time by bringing the opposite B-end of the wire into contact with the touch plate 81 when the A-end of the wire is at HIGH (second potential or state) due to its contact with the probe 41 in the wire insertion detecting jig 33. Such an operation enables the wire arbitrarily selected by the operator to be easily recognized by the CPU 43.

If the purpose is only to detect the contact of the wire, the plunger 61 may be omitted and, instead, the rod 62 may be constructed to project from the upper end of the barrel 55. In view of the fact that a force exerted by an operator to insert the terminal differs person to person and depending upon time, it is designed to easily and securely switch the potential only by distancing the rod 62 from the contact element 75 by the contact of the plunger 61 after the plunger 61 and the rod 62 are moved away from each other in the natural state.

In portions of the upper surface of the wire insertion detecting jig 33 adjacent to the opening 52a, the plurality of guiding LEDs 48 are provided preferably in correspondence with the plurality of probes 41 in the opening 52a or in the accommodating portion 52. The respective guiding LEDs 48 are connected to the lead wire 87 and the driving circuit 44 in the control unit 34 shown in FIG. 2, and are activated and deactivated, preferably turned on and off and/or blinked in accordance with a drive control executed by the CPU 43.

Identified by 84 in FIGS. 3 and 4 is a lock for preventing the connector Cn mounted in the accommodating portion 52 from coming up. A base portion 84a having a specified elasticity is rotatably supported about an axis of rotation 85 in its intermediate position by the wire insertion detecting jig 33. The leading end of a substantially wedge-shaped 84b formed at the upper end of the lock 84 at least partially overlaps the upper end of the opening 52a by biasing a bottom portion of the base portion 84a in a direction of arrow X1 by a biasing member 86 such as a coil spring. The upper surface of at least a portion of the claw 84b overlapping the upper end of the opening 52a is formed into a tapered surface 84c slanting preferably substantially downward toward the opening 52a, so that, when the connector Cn is brought into contact with the tapered surface 84c and is further pushed down, the base portion 84a is so moved, preferably so curved and/or pivoted as to bring or move the claw 84b substantially away from the opening 52a and the biasing member 86 is compressed, thereby allowing the connector Cn to be at least partly mounted into the opening 52a or accommodation portion 52. When the connector Cn is preferably substantially completely mounted into the opening 52a and is located below the leading end of the claw 84b, the leading end of the claw 84b is moved back to a position where it partially overlaps the upper surface of the connector Cn in the opening 52a by the elastic restoring force of the base portion 84a and the biasing force of the biasing member 86, thereby preventing the connector Cn from coming up out of the opening 52a.

Next, the control unit 34 is described.

An information on the mount positions of the opposite ends (A-ends and B-ends) of the wires in the connectors (i.e. the aforementioned correspondence between the wires and the probes 41) for the respective product numbers of various subassemblies is stored preferably beforehand in a nonvolatile memory (Mr in FIG. 2: storage means) e.g. a ROM, EPROM, EEPROM, CD-ROM, a storage disc, etc. provided in the control unit 34, so that A-end and B-end mounting processes and an electrical connection testing process can be efficiently performed in accordance with the information registered in the control unit 34.

A coupling piece 34a (see FIG. 1) is fixed to the bottom end of the front surface of the control unit 34, and preferably is fixedly cantilevered at the upper end of the fixed plate 35b on which the wire insertion detecting jigs 33 are provided. The bottom end of the rear surface of the control unit 34 is placed on the upper ends of the supplying channels 31 a of the wire supplying unit 31.

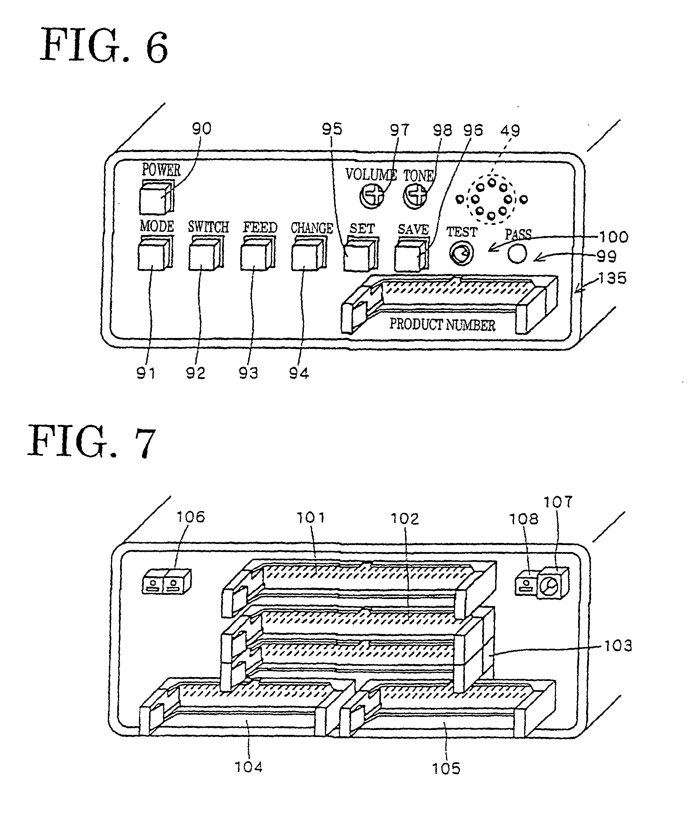

On the front surface of the control unit 34 is provided an operation panel used for the operation of the preferably entire wire mount instructing/testing apparatus. As shown in FIG. 6, various operation switches 90 to 96, the buzzer 49, a volume adjusting screw or knob 97 for adjusting a buzzing volume of the buzzer 49, a tone adjusting screw 98 for adjusting a buzzing frequency (tone) of the buzzer 49, and a success indicator or display or lamp (success LED) 99 which is turned on when the subassembly passes a test on the wire mount, a pedal connecting terminal 100 for connecting a specified pedal switch (not shown), and a connection port 135 for connecting the product number switching board 36 to be described later. The adjusting screws 97, 98 also function as a sound changing means for changing a buzzing sound and/or volume of the buzzer 49.

The operation switch 90 is a main power switch, and the operation switch 91 is a mode switch for switching a mode between a data registration mode in which data are registered for each of the product numbers of the subassemblies and an operation mode in which the wires are guided to and mounted into the connectors, and the mounted states thereof are tested. The operation switch 93 is a feed switch for successively designating the plurality of supplying channels 31 a and the instructing LEDs (see FIG. 1) of the wire supplying unit 31, the wire mount positions (positions of the probes 41 in FIG. 4) in the wire insertion detecting jigs 33, the guiding LEDs 48, etc. to specify them when the product number is registered. The operation switch 92 is a changeover switch for switching an object of the feed switch 93 to be successively changed to the wire supplying unit 31 (instructing LEDs 32 (FIG. 1), etc.), the wire insertion detecting jigs 33 (guiding LEDs 48) and the like when the product number is registered. The operation switch 94 is a change switch for erasing the product number registered in correspondence with the supplying channels 31 a of the wire supplying unit 31 or replacing an operation sequence and the correspondence with the supplying channels 31a to change them. The operation switch 95 is a set switch as a confirmation button for the contents set by the change switch 94 and other switches. The operation switch 96 is a save switch for saving the contents confirmed by the set switch 95 in the nonvolatile memory Mr shown in FIG. 2 such as an EEPROM or flash memory.

The pedal switch (automatic/manual operation designating means: not shown) connected with the pedal connecting terminal 100 is adapted to switch the operation mode of the instructing/testing apparatus between a manual testing mode and an automatic testing mode. An operator can forcibly start manual testing (manual mode) or switch to automatic operations (automatic testing mode) such as an <A-end mounting process>, an <B-end mounting process> and an <electrical connection testing process> any time by pushing the pedal switch in any case including a case where the actual operation is being performed. For example, in the case that there is a break during the actual operation, an operator may have forgotten in which step he interrupted the operation when he tries to resume the operation after the break. In such a case, the testing is started by pushing the pedal switch to judge the progress of the operation based on, e.g. the blinking state of the instructing LED 32.

Next, the rear surface of the control unit 34 is described. As shown in FIG. 7, a connecting terminal group (ports) for connecting external equipments with the respective parts of the wire mount instructing/testing apparatus is provided. Specifically, the connecting terminal group includes a guiding LED power supply port 101 for supplying a power supply of, e.g. 5 bolts to anodes of the respective guiding LEDs 48 of the wire insertion detecting jigs 33, a guiding LED driving port 102 for turning the guiding LEDs 48 on and off at their cathode sides, a probe interface port 103 connected or connectable with the rods 62 of the probes 41 of the wire insertion detecting jigs 33, an instructing LED power supply port 104 and an instructing LED driving port 105 connected or connectable with the instructing LEDs 32 of the wire supplying unit 31. The ports 101, 102 and 103 contain, for example, 60 pins, whereas the ports 104 and 105 contain, for example, 40 pins. Identified by 106 are two success output terminals for sending output signals to an external device such as stamper (not shown) for marking Success Stamp" or the like when the assembled subassembly passes the test, by 107 a power terminal to be connected e.g. with an AC adapter for the connection with a commercial power supply, and by 108 a grounding terminal connected to ground the metal plating 56 of the base plate 54 and the touch plate 81 via the ground lead wire 57.

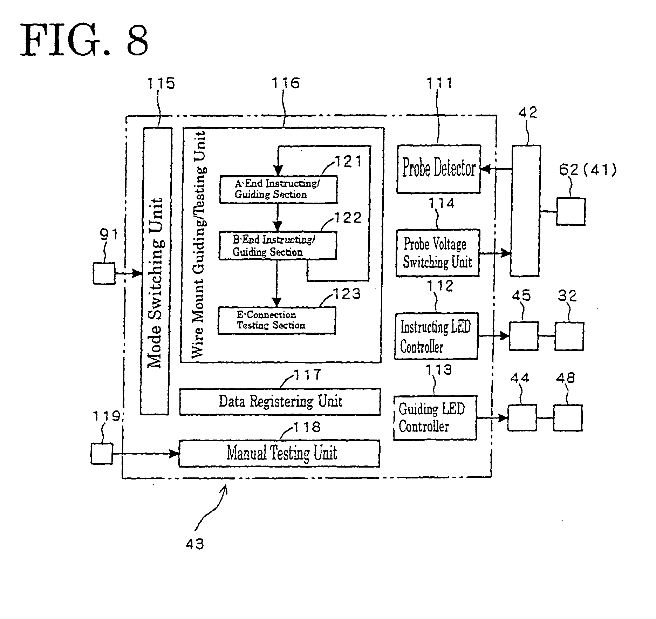

FIG. 8 is a function block diagram showing the functional construction of the CPU 43 in the control unit 34. The CPU 43 operates in accordance with a specified software program stored in the memory Mr (see FIG. 2), and is provided with a probe detector 111, an instructing LED controller 112, a guiding LED controller 113, a probe voltage switching unit 114, a mode switching unit 115, a wire mount guiding/testing unit 116, a data registering unit 117, and a manual testing unit 119 as shown in FIG. 8. The probe detector 111 detects the voltage level (HIGH or LOW) of the rod 62 of each probe 41 in accordance with a signal inputted from the detection signal input/output circuit 42. The instructing LED controller 112 controllably turns the instructing LEDs 32 on and off using the driving circuit 45. The guiding LED controller 113 controllably turns the guiding LEDs 48 on and off using the driving circuit 44. The probe voltage switching unit 114 switches the voltage level (HIGH or LOW) of the rod 62 of each probe 41 by sending a signal to the detection signal input/output circuit 42. The wire mount guiding/testing unit 116 instructs and guides the mounting of the A-ends and B-ends for a subassembly of the product number designated by the operator, and tests electrical connections after the subassembly is completed. The mode switching unit 115 switches the mode between the data registration mode and the operation mode based on the state of the mode switch 91. The wire mount guiding/testing unit 116 instructs and guides the respective ends (terminals) of the wires to the mount positions by repeating the <A-end mounting process> and the <B-end mounting process> described later for the subassembly of the product number specified by the operator, and finally performs the <electrical connection testing process> described later. The data registering unit 117 performs a <data registering process> described later when the mode is switched to the data registration mode by the mode switch 115. The manual testing unit 118 performs a <manual testing process> described later when the pedal switch 119 connected with the pedal connecting terminal 100 shown in FIG. 6 is pushed.

The units 116, 117 and 118 display their respective functions while causing the probe detector 111 to detect the voltage level of each probe 41 and the LED controllers 112 and 113 to execute controls to turn on and off and blink the respective LEDs 32, 48. The wire mount guiding/testing unit 116 includes an A-end instructing/guiding section (first instructing/guiding section) 121 for performing the <A-end mounting process>, an B-end instructing/guiding section (second instructing/guiding section) 122 for performing the <B-end mounting process>, and an electrical connection testing section 123 for performing the <electrical connection testing process>. The operations in the A-end and B-end instructing/guiding sections 121, 122 are repeated until all necessary wires are connected with the respective connectors of a subassembly of one product number, and the electrical connection testing section 123 tests the completed subassembly as a final confirmation upon completion of the operations in the sections 121, 122. More in particular, The unit 116 includes an A-end instructing/guiding section (first instructing/guiding section) 121 for instructing and guiding the mounting of the A-ends, an B-end instructing/guiding section (second instructing/guiding section) 122 for instructing and guiding the mounting of the B-ends, and an electrical connection testing section 123 for testing the electrical connections after the subassembly is completed. The operations in the A-end and B-end instructing/guiding sections 121, 122 are repeated for each wire or the operations in the B-end instructing/guiding section 122 are performed for a plurality of wires after the operations in the A-end instructing/guiding sections 121 are performed for them until all necessary wires are connected with the respective connectors of the subassembly of one product number, and the electrical connection testing section 123 tests the completed subassembly as a final confirmation upon completion of the operations in the sections 121, 122.

The respective functional elements 111 to 123 in the CPU 43 are all defined preferably as subprograms or subroutines of the software program or parts of a specified program. Here, no description is given on the details of the individual operational functions since they are described later under captions <A-end mounting process>, <B-end mounting process>, <electrical connection testing process> and <data registering process>.

The volume and tone adjusting screws 97, 98 provided on the front surface of the control unit 34 are adapted to change the buzzing volume and the buzzing frequency (tone) of the buzzer 49 by being rotated or manipulated. In the case that a plurality of wire mount instructing/testing apparatuses are installed close to each other, the buzzing sounds of the respective apparatuses are made distinguishable using these screws 97, 98 in order to prevent confusion.

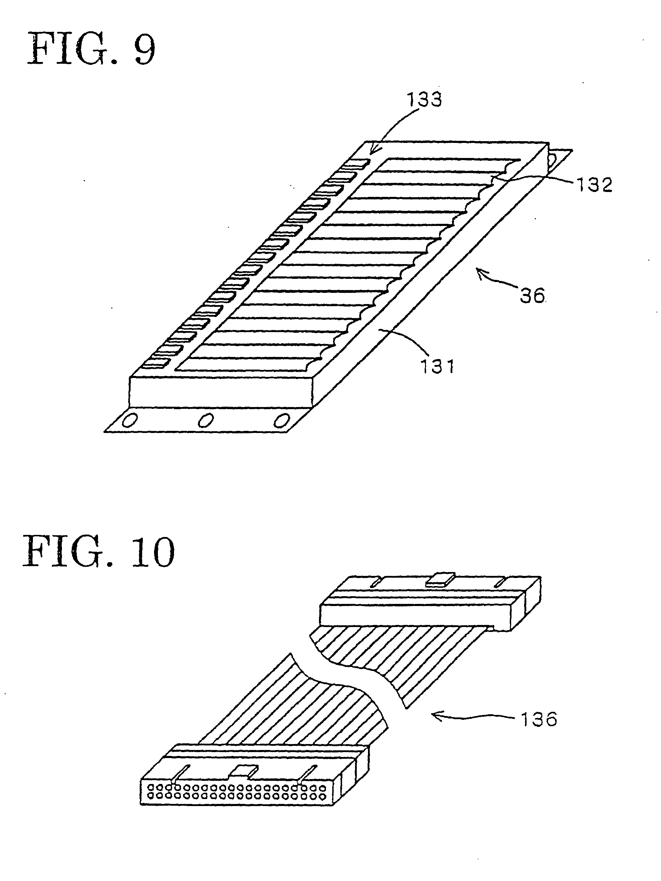

A plurality of types of products (e.g. 16 types of products) can be switchingly set using the product number switching board 36. Specifically, as shown in FIG. 9, paper number tickets bearing product numbers are replaceably inserted into a plurality of holders 132 provided on the upper surface of a board main body 131 to construct a product number list. An operator can instruct a desired product number by pushing one of product number switches 133 e.g. in the form of push-buttons arranged at the left side of holders 132 while looking at the product numbers written on the number tickets in the holder 132. Here, the product number switches 133 are made e.g. of a transparent resin of red, yellow or other color, and light emitters (not shown) such as LEDs are provided at the rear sides of the switches 133. When the product number switch 133 is pushed, the light emitter on its rear side immediately emits a light to illuminate the product number switch 133, displaying the product number designated by the operator by illumination. The switching board 36 is connected to the connection port 135 (see FIG. 6) provided on the front surface of the control unit 34 via a flat cable 136 shown in FIG. 10.

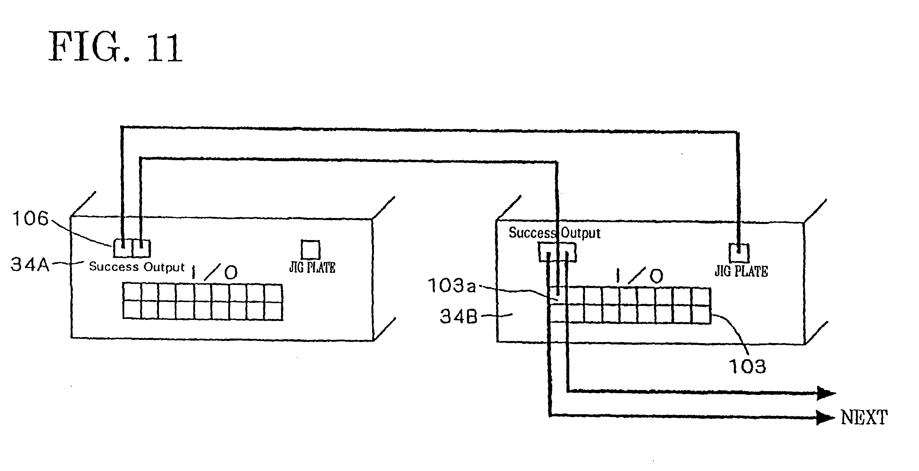

In the case that quite a few wires plan to be assembled, particularly all wires cannot be assembled by one wire mount instructing/testing apparatus, a plurality of wire mount instructing/testing apparatuses are connected in series and/or in parallel and used in combination to significantly increase the numbers of connectors and wires to be handled. Specifically, taking advantage of the function of the control unit 34 to output a success signal representing successes in all tests on the wire mount conducted by the control unit 34 from the success output terminals 106 provided on the rear surface of the control unit 34 as shown in FIG. 11, one of the two success output terminals 106 of a control unit 34A of one wire mount instructing/testing apparatus is connected with one connection pin 103a of the probe interface port 103 of the other apparatus 34B, whereas the other of the two success output terminal 106 is connected with the grounding terminal 108 of the other apparatus. In such a case, the final apparatus outputs a success signal by taking a logic multiplication of the successes in all tests in the first apparatus and the successes in all tests in the second apparatus. In this way, a success signal representing successes in all tests in a plurality of wire mount instructing/testing apparatuses can be outputted at once. If, for example, the probe interface port 103 contains 60 connection pins, one of the 60 connection pins of the probe interface port 103 of the second or succeeding wire mount instructing/testing apparatus is used for the apparatus-to-apparatus connection, but the remaining 59 pins can be used for the tests.

Identified by 139 in FIG. 1 is a notice board for pinning up memos having an operation schedule or the like written thereon by magnets or clips.

### <Operations>

The wire mount instructing/testing apparatus thus constructed is adapted to mount or control the mounting the respective wires into a plurality of connectors at once and simultaneously test the mounted states of the wires preferably using the wire insertion detection jigs 33. The wires to be taken out are successively instructed to the operator by the instructing LEDs 32, whereas the positions in the connector into which the respective terminals of the wires should be inserted are instructed by the guiding LEDs (point guides) 48. Accordingly, a defect caused by a misarragement can be prevented, and whether or not the wire was properly inserted can be tested based on an electrical connection. Thus, quality assurance in the manufacturing process can be achieved without increasing the number of operation steps. How this wire mount instructing/testing apparatus is used is described below.

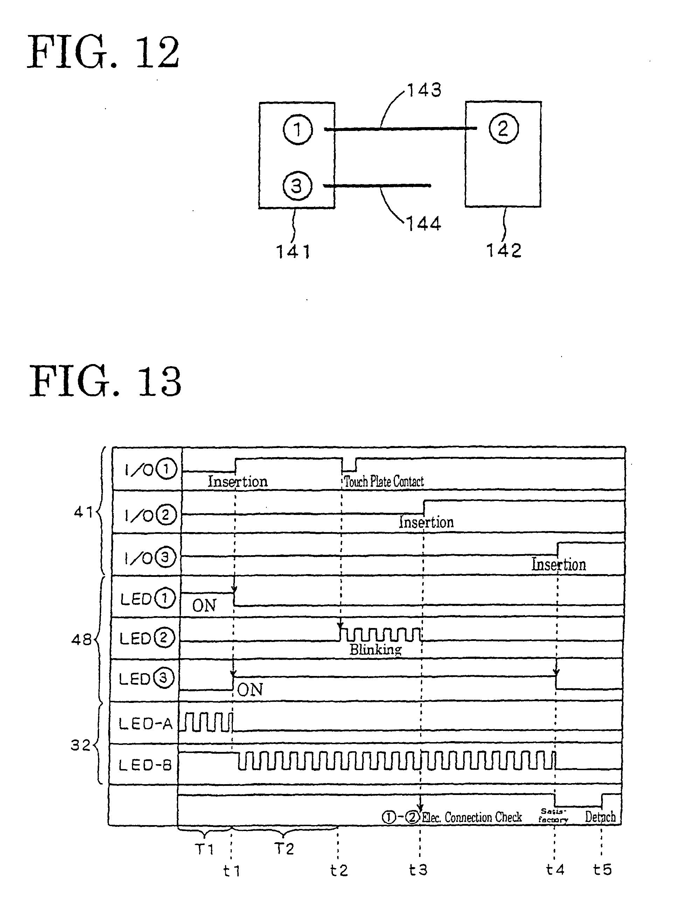

An overall flow of operations is briefly described before describing the operations in detail. For an easier understanding, a subassembly of a wiring harness as shown in FIG. 12 is used as an example. In this wiring harness subassembly, one cavity ① of a connector 141 at an A-end and one cavity ② of a connector 142 at a B-end are connected by one wire 143. Another wire 144 is connected with another cavity ③ of the connector 141, but not with the connector 142.

An operation procedure in this case is as shown in a timing chart of FIG. 13. Specifically, if an operation is started with none of the probes 41 contacted by the wire, the instructing LED 32 (LED-A in FIG. 13) of the supplying channel 31a for accommodating wires to be first taken out to form this subassembly is blinked, and all other instructing LEDs 32 (LED-B in FIG. 13) corresponding to the wires used for this subassembly are turned on during a time T1 in FIG. 13. Simultaneously, the guiding LED 48 (LED ①) corresponding to the cavity ① of the A-end side wire insertion detecting jig 33 in which the A-end side connector 141 is turned on. Since no wire is in contact with any of the probes 41 at this stage, all the probes 41 (I/O① to I/O③ in FIG. 13) are held at LOW (first potential) by being grounded by the barrels 55.

An operator mounts the A-end of the wire 143 of FIG. 12 into the cavity ① of the connector 141 in accordance with the turned-on guiding LED 48 (LED① in FIG. 13). Then, the voltage level of the probe 41 pressed by the A-end of the wire 143, i.e. the I/O① in FIG. 13 rises to HIGH (second potential) and, accordingly, the guiding LED 48 (LED① in FIG. 13) having been on is turned off. Almost simultaneously, the guiding LED 48 (LED③ in FIG. 13) corresponding to the cavity ③ (see FIG. 12) of the connector 141 in the A-end side wire insertion detecting jig 33 into which a wire should be inserted next is turned on. Further, the blinking instructing LED 32 (LED-A in FIG. 13) is turned off, and the instructing LED 32 (LED-B in FIG. 13) of the supplying channel 31a accommodating the wire to be taken out next is blinked.

At this stage, the operator may mount the A-end of the wire 144 into the cavity ③ of FIG. 12 in accordance with the instructing LED 32 turned on. However, it is frequently a more convenient operation to first complete the wire 143 already being handled. In such a case, the operator brings the B-end of the wire 143 into contact with the touch plate 81 at t2 after the lapse of a period T2. Since the touch plate 81 is grounded, the voltage level of the wire falls to LOW at t2, which is sent to the I/O① in FIG. 13 of the probe 41 pressed by the A-end of the wire 143 to change the state thereof to LOW. The CPU 43 of the control unit 34 detects such a change and causes the guiding LED 48 (LED② in FIG. 13) corresponding to the cavity ② of the connector 142 in the B-end side wire insertion detecting jig 33 for the B-end of the wire 143 to blink. The operator inserts the B-end of the wire 143 into the cavity ② (see FIG. 12) of the connector 142 in the B-end side wire insertion detecting jig 33, for example, at t3 upon looking at the blinking guiding LED 48 (LED② in FIG. 13). In the cavity ②, the probe 41 is pressed to rise the voltage level of the I/O② in FIG. 13 to HIGH and, accordingly, the guiding LED 48 (LED② in FIG. 13) having been on is turned off.

After t3, the LED③ and the LED-B in FIG. 13 are held on and blinking, respectively. The operator takes the next wire 144 from the supplying channel 31a corresponding to the blinking instructing LED 32 (LED-B in FIG. 13), and inserts the A-end of the wire 144 into the cavity ③ of FIG. 13, for example, at t4. At this time, similar to the above, the voltage level of I/O③ of FIG. 13 rises to HIGH and, accordingly, the guiding LED 48 (LED③ in FIG. 13) having been on is turned off and the blinking instructing LED 32 (LED-B in FIG. 13) is turned off. In this case, a success is notified to the operator for the judgment of success in the state shown in FIG. 12. Thereafter, the completed wiring harness subassembly comprised of the wires 143, 144 and the connectors 141, 142 is taken out from the respective wire insertion detecting jigs 33 at t5.

The <data registering process> described later is carried out using a specified harness model having substantially the same connection construction as the one shown in FIG. 12. Thus, data on the instructions and guides for the insertions to form the subassembly are stored in the memory Mr by extraction teaching or teach-in of a reference sample. A time required for the data registration can be advantageously shortened by extraction teaching. A teach-in procedure may include the following steps: inserting a model connector or harness into the corresponding jigs and detecting the circuit formed by such model connectors or harness e.g. by applying a current or voltage or signal to the probes 41; then, after the model has been withdrawn the instructing indicators 32 are subsequently activated to instruct the wire to be taken from a supplying channel 31a. Then the operator chooses the insertion hole Cab of the connector Cn to teach where the respective wire end should be inserted. Once the wire is inserted (detected e.g. by the change in voltage of a probe 41 of the connector Cn) the system or control 34 already knows where the other end of the wire ("B-end") should be inserted, as this is already known from the model connectors or harness. Accordingly, there is no need to teach in the insertion position of the B-end of the wire.

The above operations are described in detail, centered on exemplary operations of assembling a subassembly by, after the A-end and B-end of one wire are connected with the connector, performing similar operations for the succeeding wires.

Hereafter, how the wire mount instructing/testing apparatus is used is described even more in detail. For this operation, various pieces of information including a relationship in connection between the respective wires 143, 144 and the connectors 141, 142 and an information on the supplying channels 31a accommodating the respective wires 143, 144 are registered beforehand in the memory Mr in the control unit 34 of the wire mount instructing/testing apparatus using a model harness having substantially the same construction as the subassembly shown in FIG. 12.

FIG. 13 is a timing chart showing an operation procedure of this wire mount instructing/testing apparatus. When this apparatus is started with none of the probes 41 contacted by the wire, the A-end of the wire 143 of the subassembly as shown in FIG. 12 is inserted into the cavity ① of the A-end side connector 141.

At this stage, the CPU 43 first sends a specified signal to the driving circuit 44 to blink the instructing LED 32 (LED-A in FIG. 13) corresponding to the supplying channel 31a accommodating the wire of the subassembly to be first taken out and to turn all the other instructing LED(s) 32 (LED-B in FIG. 13) on to be used for this subassembly during a time T1 in FIG. 13. Simultaneously, the guiding LED 48 (LED in FIG. 13) corresponding to the cavity ① of the A-end side wire insertion detecting jig 33 in which the A-end side connector 141 is mounted is turned on.

Since the wires are not in contact with the probes 41 in the wire insertion detecting jigs 33 at this stage, the spring bearing portions 65 of the plungers 61 of the probes 41 are biased upward by the biasing members 63 in the natural state (state where the wires are not in contact) as shown in FIG. 5A and, accordingly, the bottom ends of the plungers 61 are located above and distanced from the spring bearing portions 73 of the rods 62 provided below the plungers 61 as shown in FIG. 5B. Thus, the rods 62 are also held in their natural state, and the spring bearing portions 73 of the rods 62 are biased upward by the biasing members 74 to bring the rods 62 (I/O① to I/O③ in FIG. 13) of all the probes 41 into contact with the conductive contact elements 75, thereby holding the rods 62 at the same ground potential (first potential: LOW) as the barrels 55.

The operator inserts the A-end of one wire 143 in FIG. 12 into the cavity ① of the connector 141 in accordance with the turned-on guiding LED 48 (LED① in FIG. 13) at t1. Then, the A-end of the wire 143 comes into contact with the leading end head 66 of the probe 41 as indicated by WH in FIG. 5C, thereby pushing the probe 41 down. At this time, the plunger 61 is moved downward against the biasing force of the biasing member 63 in the barrel 55 and its bottom end 61a comes into contact with the spring bearing portion 73 of the rod 62 to push the rod 62 down as shown in FIG. 5C. The rod 62 is moved downward against the biasing force of the biasing member 74 in the barrel 55, with the result that the rod 62 and the contact element 75 are distanced from each other to cancel an electrical connection between the rod 62 and the barrel 55. Since the bottom end of the rod 62 of the probe 41 is connected to the power supply of, e.g. 5 bolts via the lead wire 78 and the pull-up resistor 79 as shown in FIG. 2, the rod 62 is electrically disconnected from the barrel 55 held at ground potential, changing the voltage level thereof from LOW to HIGH. Such a voltage change is sent to the CPU 43 via the detection signal input/output circuit 42, and the CPU 43 detects that the A-end of the wire has been inserted into the cavity Cab of the connector Cn corresponding to the position of the probe 41 whose voltage level had risen to HIGH (second potential).

Upon such a detection, the CPU 43 sends a specified signal to the driving circuit 45 and turns off the guiding LED 48 (LED① in FIG. 13) having been on and turns on the guiding LED 48 (LED② in FIG. 13) corresponding to the cavity ③ (see FIG. 12) of the connector in the A-end side wire insertion detecting jig 33 into which a wire end is inserted next. Further, the CPU 43 sends a specified signal to the driving circuit 44 to thereby turn the blinking instructing LED 32 (LED-A in FIG. 13) off and blink the instructing LED 32 (LED-B in FIG. 13) of the supplying channel 31a accommodating the wire to be taken out next.

At this stage, the operator may insert the A-end of the other wire 144 into the cavity ③ in FIG. 12 when the guiding LED 48 corresponding to the cavity ③ (see FIG. 12) is turned on. However, it is frequently a more convenient operation to first complete the first wire 143 having been handled. In such a case, the operator wants to insert the B-end of the first wire 143 into the cavity ② before inserting the wire end into the cavity ③ in FIG. 12.

In such a case, the operator notifies his intention to insert the B-end to the wire mount instructing/testing apparatus by bringing the B-end of the wire 143 into contact with the touch plate 81 at t2 which is reached after a lapse of time T2 following t1.

Since the touch plate 81 is grounded, the voltage level of the wire 143 falls to LOW at t2. At this time, the bottom end 61 a of the plunger 61 is brought into contact with the spring bearing portion 73 of the rod 62 to push the rod 62 down as shown in FIG. 5C in the probe 41 in the cavity ① of the connector 141 in the A-end side wire insertion detecting jig 33. Accordingly, the rod 62 and the contact element 75 are distanced from each other to cancel an electrical connection between the rod 62 and the barrel 55. However, since the voltage level of the wire 143 falls to LOW at t2, the voltage levels of the plunger 61 and the rod 62 also fall to LOW. In other words, the state LOW of the I/O① of the probe 41 in the A-end side wire insertion detecting jig 33 at t2 is sent to the CPU 43 of the control unit 34, and the CPU 43 starts guiding the B-end.

At this stage, the CPU 43 sends a specified signal to the driving circuit 44 to blink the guiding LED 48 (LED② in FIG. 13) corresponding to the cavity ② (see FIG. 12) of the connector 142 in the B-end side wire insertion detecting jig 33 into which the B-end of the wire 143 is to be inserted. Upon looking at the blinking guiding LED 48 (LED② in FIG. 13), the operator inserts the B-end of the wire 143 into the cavity ② (see FIG. 12) of the connector 142 in the B-end side wire insertion detecting jig 33, for example, at t3. In the cavity ②, the probe 41 is pushed down to rise the voltage level of the I/O② in FIG. 13 to HIGH. In response thereto, the CPU sends a specified signal to the driving circuit 44 to turn the blinking guiding LED 48 (LED② in FIG. 13) off.

During this time, the LED③ (guiding LED 48) and the LED-B (instructing LED 32) in FIG. 13 are kept turned on and blinking, respectively. Upon looking at these states, the operator inserts the A-end of the other wire 143 at t4. Specifically, the operator takes the next wire 144 out from the supplying channel 31a corresponding to the blinking instructing LED 32 (LED-B in FIG. 13), and inserts the A-end of the wire 144 into the cavity ③ in FIG. 10 while looking at the turned-on LED ③ (guiding LED 48), for example, at t4. At this time, the A-end of the wire 144 comes into contact with the leading end head 66 of the probe 41 as indicated by WH in FIG. 5C to push it down. Then, the plunger 61 is moved downward against the biasing force of the biasing member 63 in the barrel 55 as shown in FIG. 5C, and the bottom end 61a thereof comes into contact with the spring bearing portion 73 of the rod 62 to push it down. The rod 62 is moved downward against the biasing force of the biasing member 74 in the barrel 55, with the result that the rod 62 is distanced from the contact element 75 to cancel an electrical connection between the rod 62 and the barrel 55. As shown in FIG. 2, the bottom end of the rod 62 of this probe 41 is connected with the power supply of, e.g. 5 bolts via the lead wire 78 for external connection and the pull-up resistor 79. Accordingly, the voltage level of the rod 62 electrically disconnected from the barrel 55 held at ground potential is switched from LOW to HIGH as shown in I/O③ of FIG. 13. In response thereto, the CPU 43 sends a specified signal to the driving circuit 45 to turn off the guiding LED 48 (LED③ in FIG. 13) having been on and the blinking instructing LED 32 (LED-B in FIG. 13). Finally, whether or not the A-ends and B-ends of the wires 143, 144 are properly electrically connected is tested based on an information stored beforehand in the memory Mr. In the case of passing the test, a success is notified to the operator by means of the specified buzzer 49 or a specified success lamp (not shown) or the like. Thereafter, a completed subassembly (see FIG. 12) comprised of the wires 143, 144 and the connectors 141, 142 is taken out of the respective wire insertion detecting jigs 33.

Although the A-end and B-end of the second wire 144 are mounted after those of the first wire 143 are mounted in this example, the B-ends of the wires 143, 144 may be mounted after the A-ends thereof are mounted.

For the above operation, in the wire insertion detecting jig, the barrels 55 at the outer peripheries of all the probes 41 are adhered to the metal plating 56 on a plurality of through holes of the base plate 54 and are commonly grounded by the one ground lead wire 57. In other words, the probes 41 can be grounded using the single ground lead wire 57 even if there are many probes 41 provided in correspondence with the cavities of the connector. Accordingly, a large space is not required for the wiring for connection, and the wiring layout can be simplified, with the result that a wire insertion detecting jig having an excellent wiring efficiency for the connection between the wire insertion detecting jig 33 and the control unit 34 can be provided.

Although the metal plating 56 is so formed as to extend from the through holes 53 to the entire upper and lower surfaces of the base plate 54 in the foregoing embodiment, it may be formed on either one of the upper and lower surfaces or may not be necessarily entirely formed on the both or one surface of the base plate 54 provided that all the through holes 53 can be commonly connected.

### <Initial Process>

In an initial state, the mode switch 91 grounded to the front surface of the control unit 34 shown in FIG. 6 is set to the operation mode.

First, connectors Cn desired to be assembled are mounted in the openings 52 of the wire insertion detecting jig 33 prepared for the A-ends (hereinafter, "A-end side wire insertion detecting jig 33") and the wire insertion detecting jig 33 prepared for the B-ends (hereinafter, "B-end side wire insertion detecting jig 33"), respectively. As shown in FIG. 4, each connector Cn is pushed further down while being brought into contact with the tapered surface 84c of the lock 84 provided at the opening 52a of the wire insertion detecting jig 33 from above. At this time, the base 84a of the lock 84 is curved so that the claw 84b thereof is moved sideways away from the opening 52a, and the biasing member 86 is compressed, with the result that the insertion of the connector Cn into the opening 52a is permitted. When the upper end of the connector Cn slips under the leading end of the claw 84b of the lock 84 by further inserting the connector Cn into the opening 52a, the leading end of the claw 84b partially overlaps the upper surface of the connector Cn in the opening 52a by the elastic restoring force of the base 84a and/or the biasing force of the biasing member 86. This prevents the connector Cn from coming up out of the opening 52a.

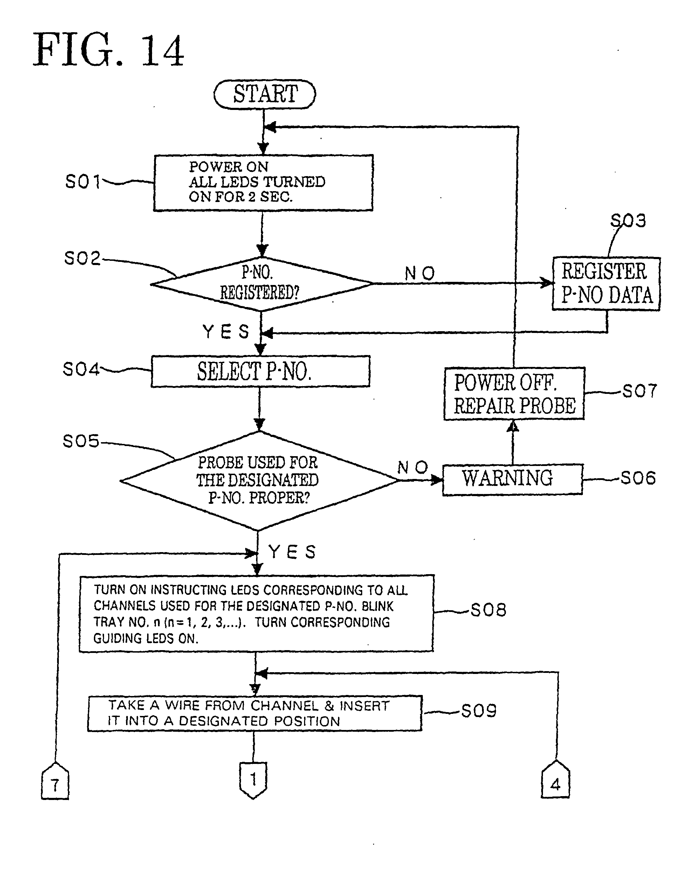

Next, the main power switch 90 provided on the front surface of the control unit 34 shown in FIG. 6 is pushed to turn a main power supply on (Step S01 of a flow chart of FIG. 14). At this stage, control signals are sent to the driving circuits 44, 45 in FIG. 2 from the CPU 43 in the control unit 34 to turn on all the instructing LEDs 32 corresponding to the respective supplying channels 31a of the wire supplying unit 31 and all the guiding LEDs 48 of all the wire insertion detecting jig 33 for about 2 sec. The operator can check whether or not any of the lamps has burnt out by confirming whether or not all the LEDS 32, 48 are on at this time. Thus, he can securely find out an abnormality of the lamps themselves prior to the operation. It should be noted that all the light emitters provided at the rear surfaces of the product number switches 133 of the product number switching board 36 (see FIG. 9) are all off.

Next, the operator judges whether or not the product number of the subassembly to be formed is already registered in Step S02 of FIG. 14. In such a case, the operator can judge that this product number is already registered if it is listed or not registered yet if it is not listed by looking at the number tickets in the holders 132 of the product number switching board 36 (see FIG. 9). Even if the product number switch 133 is pushed at this stage, the light emitter will not be turned on if the corresponding product number is not registered yet. Based on this, the operator can easily confirm that the product number is not registered yet. In such a case, this product number is registered in accordance with the data registering process described later in Step S03 of FIG. 14.

If the product number is registered in Step S03 or is judged to be already registered in Step S02, the operator selects a desired product number by pushing a corresponding product number switch 133 provided at the left side of the holders 132 of the product number switching board 36 while looking at the product numbers written on the number tickets in the holder 132 forming a product number list. Then, the light emitter at the rear surface of the pushed product number switch 133 emits a light to illuminate this product number switch, and a program in the memory Mr corresponding to this product number is selected.

The CPU 43 judges whether or not all the probes 41 to be used for the selected product number are proper in Step S05 of FIG. 14. In the natural state (not contacted by the wire) of each probe 41 in the wire insertion detecting jig 33, the spring bearing portion 65 of the plunger 61 is biased upward by the biasing member 63 and, accordingly, the rod 62 below the plunger 61 is also held in its natural state, i.e. the spring bearing portion 73 of the rod 62 is biased upward by the biasing member 74 to hold the rod 62 in contact with the contact element 75 at the same ground potential (low state) as the barrel 55. Accordingly, if the level of a signal inputted to the CPU 43 via the detection signal input/output circuit 42 as shown in FIG. 2 is HIGH at this point, a corresponding abnormality of the probe 41 can be judged. Thus, the guiding LED 48 corresponding to the abnormal probe 41 is turned on in Step S06 of FIG. 14, and the buzzer 49 is operated to give a warning to the operator. In this case, the operator repairs the probe 41 in accordance with a specified procedure such as a start inspection in Step S07 of FIG. 14.

After completion of the above initial process, the following <A-end mounting process> and <B-end mounting process> are successively performed for the first wire.

### <A-End Mounting Process>

In Step S08, the CPU 43 controls the driving circuit 45 to blink the instructing LED 32 of the supplying channel 31a accommodating the wire to be first (n = 1 in the block of Step S08 of FIG. 14) mounted to form the subassembly of the selected product number out of all the instructing LEDs 32 corresponding to the supplying channels 31a accommodating the wires to be used for this assembly. Simultaneously, the instructing LEDs 32 corresponding to all the supplying channels 31a accommodating all kinds of wires to be used for this subassembly are turned on because a plurality of kinds of wires are normally used to form the subassembly of the selected product number. Then, out of the guiding LEDs 48 of the A-end side wire insertion detecting jig 33, only the guiding LED 48 corresponding to the cavity Cab (see FIG. 4) of the connector Cn into which the first wire should be mounted is turned on.

The operator draws an A-end of a wire in the supplying channel 31a corresponding to the singly blinking instructing LED 32 out through the upper opening 31b, and inserts this A-end into the corresponding cavity Cab of the connector Cn in the opening 52a corresponding to the turned-on guiding LED 48 of the A-end side wire insertion detecting jig 33 in Step S09.

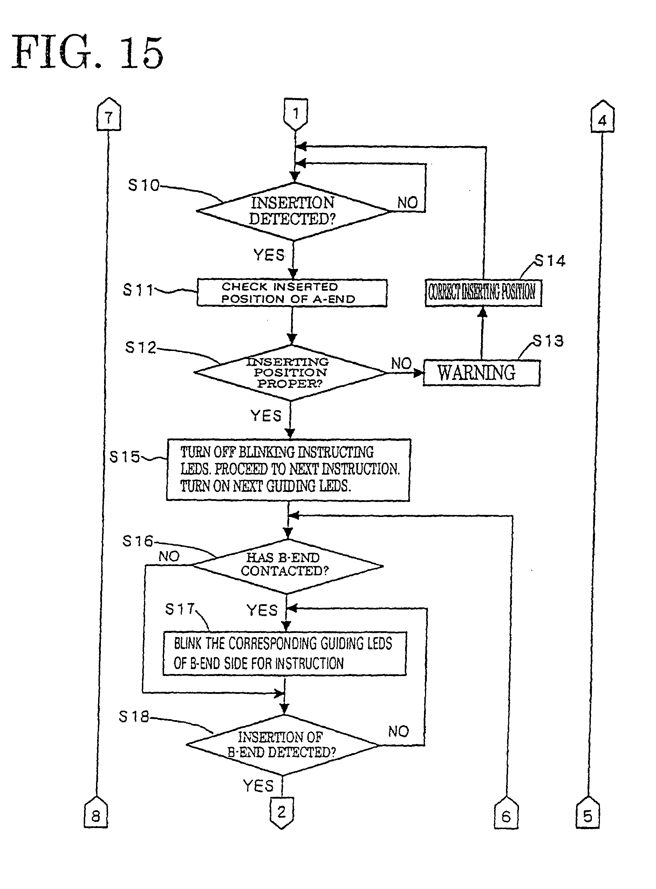

Then, the A-end of the wire comes into contact with the leading end head 66 of the probe 41 shown in FIGS. 4 and 5A to push it down. At this time, the plunger 61 is moved downward in the barrel 55 against the biasing force of the biasing member 63, and the bottom end 61 thereof is brought into contact with the spring bearing portion 73 of the rod 62 to push it down. The rod 62 is moved downward in the barrel 55 against the biasing force of the biasing member 74, moving the rod 62 and the contact element 75 away from each other, with the result that an electrical connection between the rod 62 and the barrel 55 is canceled. Since the bottom end of the rod 62 of the probe 41 is connected to a power supply of, e.g. 5 bolts via the lead wire 78 and the pull-up resistor 79, the voltage level of the rod 62 changes from LOW to HIGH by being electrically disconnected from the barrel 55 at ground potential. Such a voltage change is sent to the CPU 43 via the detection signal input/output circuit 42, and the CPU 43 detects that the A-end of the wire is inserted into the cavity Cab of the connector Cn corresponding to the position of the probe 41 whose voltage level has risen to HIGH (second potential) (Step S10 of FIG. 15).

Here, the CPU 43 checks the inserted position of the A-end of the wire based on the information already registered in the memory Mr in Steps S11 and S12 of FIG. 15. Specifically, the CPU 43 judges that the inserted position of the A-end is wrong if the voltage level of the probe 41 different from the expected probe 41 has risen, and sends a specified signal to the driving circuit 46 to cause the buzzer 49 to intermittently send out short buzzing sounds, thereby giving the operator a warning that the inserted position of the A-end is wrong. The operator corrects the inserted position of the A-end in response to such a warning in Step S14 of FIG. 15, and carries out the operations after Step S10 again.

On the other hand, if the CPU 43 judges that the inserted position of the A-end is proper, Step S15 of FIG. 15 follows, in which the CPU 43 sends specified signals to the driving circuits 44, 45 to turn off the blinking instructing LED 32 and the turned-on guiding LED 48. Further, the instructing LED 32 of the supplying channel 31 a accommodating a wire to be inserted next is blinked in view of a possibility that the operator wants to mount an A-end of an other wire without mounting the B-end of this wire next.

### <B-End Mounting Process>

Here, a case where, after the A-end of one wire is inserted into a connector, the B-end thereof is inserted into another connector is described.

At this stage, in the A-end side wire insertion detecting jig 33 in which the connector Cn is mounted, the A-end of the wire is in contact with the probe 41 and, accordingly, the rod 62 and the plunger 61 of the probe 41 are electrically disconnected from the grounded barrel 55. Since a power is applied to the rods 62 and the plungers 61 via the pull-up resistor 79 as shown in FIG. 2, the voltage levels of the rods 62 of the respective probes 41 are held at HIGH, and the HIGH voltage levels of the rods 62 are inputted to the CPU 43 via the detection signal input/output circuit 42. The probes 41 in the B-end side wire insertion detecting jig 33 are held in their natural state since no wire is in contact therewith. Thus, as shown in FIG. 5A, the spring bearing portions 65 of the plungers 61 are biased upward by the biasing members 63 to hold the rods 62 in their natural state and, therefore, the spring bearing portions 73 of the rods 62 are biased upward by the biasing members 74 to bring the rods 62 into contact with the conductive contact elements 75 to hold them at the same ground potential (LOW) as the barrel 55.

In this state, the operator arbitrarily selects the wire having its A-end mounted in the connector, and brings the B-end of the selected wire into contact with the touch plate 81 shown in FIGS. 3 and 4. Since the touch plate 81 is grounded via the ground lead wire 57 as shown in FIG. 4, the voltage level of the wire brought into contact with the touch plate 81 falls to LOW. Then, the voltage level of the plunger 61 (see FIGS. 4 and 5A) in contact with the A-end of the wire falls to LOW, with the result that the voltage level of the rod 62 in contact with the plunger 61 also falls to LOW (see FIGS. 4 and 5A).

The CPU 43 detects whether or not the B-end of the wire has contacted the touch plate 81 based on the voltage change in the probe 41 in the A-end side wire insertion detecting jig 33 (Step S16 of FIG. 15), confirms that the operator's arbitrary intention to mount the B-end of the wire and specified the wire to be mounted.

The CPU 43 sends a specified signal to the driving circuit 44 to blink the guiding LED 48 corresponding to the proper inserted position of the B-end of the wire in the B-end side wire insertion detecting jig 33 in Step S17 of FIG. 15. This guiding LED 48 continues to be blinked even after the operator disengages the B-end of the wire from the touch plate 81. Specifically, since the wire is no longer grounded if the operator disengages the B-end of the wire from the touch plate 81, the voltage level of the rod 62 of the probe 41 in contact with the A-end of the wire returns again to HIGH, which is detected by the PU 43. However, the one guiding LED 48 of the B-end side wire insertion detecting jig 33 continues to be blinked via the driving circuit 44. Simultaneously, the guiding LED 48 of the A-end side wire insertion detecting jig 33 corresponding to the A-end of the second wire to be mounted is left turned on without being turned off.

The operator looks at the blinking guiding LED 48 of the B-end side wire insertion detecting jig 33 and inserts the B-end of the wire into the corresponding cavity Cab of the connector Cn. Then, in the B-end side wire insertion detecting jig 33, the rod 62 and the plunger 61 of the probe 41 are electrically disconnected from the barrel 55 since the B-end of the wire comes into contact with the probe 41 to push it down, and the voltage level of the rod 62 of the probe 41 rises from its initial state, i.e. changes from LOW to HIGH. Such a voltage change in the rod 62 is sent to the CPU 43 via the detection signal input/output circuit 42, and the CPU 43 detects that the B-end of the wire has been inserted into the cavity Cab of the connector Cn corresponding to the position of the probe 41 whose voltage level had risen to HIGH (Step S18 of FIG. 15).

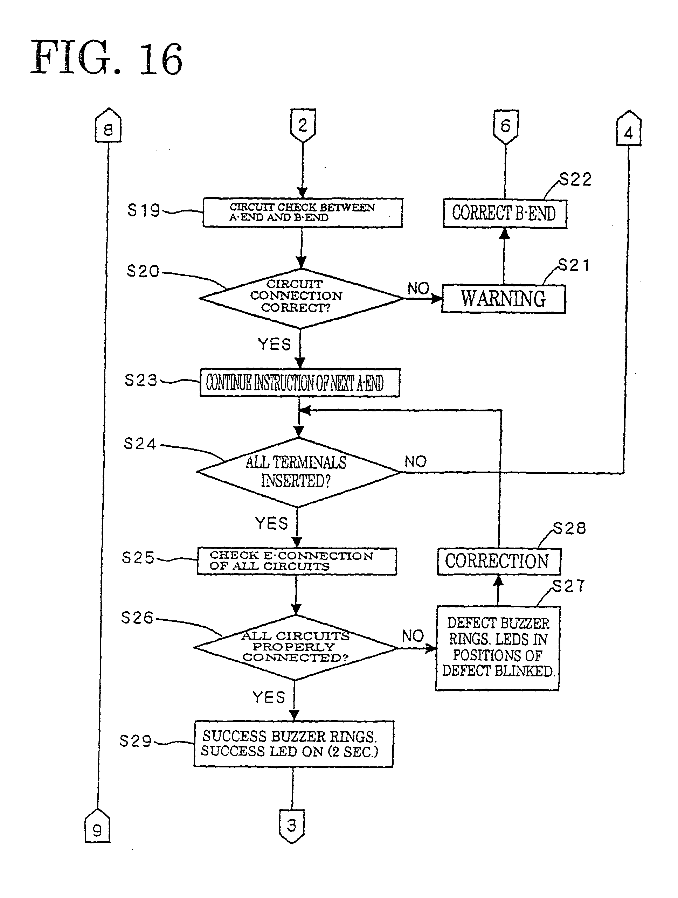

In Steps S19 and S20 of FIG. 16, a correspondence between the probe 41 having detected the insertion of the wire end in the A-end side wire insertion detecting jig 33 and the probe 41 having detected the insertion of the wire end in the B-end side wire insertion detecting jig 33 is checked. If the voltage level of the probe 41 different from the one expected by the PCU 43 has risen to HIGH, the CPU 43 judges that the B-end of the wire has been inserted in a wrong position and sends a specified signal to the driving circuit 46 to cause the buzzer 49 to repeatedly send out intermittent short buzzing sounds, thereby warning the operator of an error insertion of the B-end (Step S21 of FIG. 16). In such a case, the operator corrects the inserted position of the B-end in accordance with the warning (Step S22 of FIG. 16).

On the other hand, if the CPU 43 judges that the B-end has been inserted in a proper position, it sends a specified signal to the driving circuits 44, 45 to turn off the blinking instructing LED 32 and the guiding LED 48 corresponding to the mounted wire.

The above guiding and testing operations are also performed when the operator forgets to bring the B-end into contact with the touch plate 81, and an automatic electrical connection testing process follows if the B-end is properly inserted in this case.

### <Repeating Process>

The above A-end and B-end mounting processes are repeated for each wire to be inserted.

Specifically, in order to urge the operator to mount the A-end of a next wire into the connector Cn, the CPU 43 causes the instructing LED 32 of the supplying channel 31a accommodating this wire to blink and turns on the guiding LED 48 corresponding to the cavity Cab of the connector Cn in the A-end side wire insertion detecting jig 33 (Step S23 of FIG. 16). Similar to the mounting of the first wire, the operator inserts the A-end of the second wire into the proper cavity Cab of the connector Cn in accordance with the blinking instructing LED 32 and the turned-on guiding LED 48. Then, these instructing LED 32 and the guiding LED 48 are turned off. Thereafter, similar to the mounting of the first wire, the B-end mounting process is performed for the second wire.

Similarly, the third and subsequent wires are mounted, and the operations of Steps S09 to S23 are repeated until the A-ends and B-ends of the wires are mounted into all the cavities Cab of one connector Cn in each wire insertion detecting jigs 33 (Step S24 of FIG. 16).

A subassembly can be completed by repeating the <A-end mounting process> and the <B-end mounting process> for each wire. However, since the <B-end mounting process> is started when the operator brings the B-end of the wire into contact with the touch plate 81 at a desired timing in Step S16 of the <B-end mounting process>, the <B-end mounting process> is not started unless the operator brings the B-end into contact with the touch plate 81. Instead of such an operation, the operator may take an other wire corresponding to the blinking instructing LED 32 out from the supplying channel 31a and insert it into the cavity Cab of the connector Cn corresponding to the turned-on guiding LED 48. In such a case, the CPU 43 forcibly returns to the operations of Step S10 and subsequent Steps instead of the operations of Step S16 and subsequent Steps, thereby enabling selection of mounting of the A-end of an other wire. Accordingly, all B-ends may be mounted after the A-end of all the wires are mounted as in a case where the apparatuses according to the first and second prior arts are used in combination such as a case where a plurality of wires are inserted through a specified tube, or conversely the A-end and B-end of a next wire are mounted into the connectors after the A-end and B-end of one wire are mounted, i.e. each wire is completely mounted into the connectors before a next wire is mounted. Therefore, there is an advantage that the operator can freely select the operation sequence of the mounting processes.

### <Electrical Connection Testing Process>

Next, the CPU 43 preferably carries out an electrical connection test between the A-ends of the wires mounted in the connector Cn in the A-end side wire insertion detecting jig 33 and the B-ends of the wires mounted in the connector Cn in the B-end side wire insertion detecting jig 33 (Steps S25, S26 of FIG. 16). At the start of this electrical connection test, the A-ends and B-ends of the respective wires are electrically disconnected from the grounded barrels 55 (see FIGS. 4 and 5A) as described above since being in contact with the probes 41 in the connectors Cn.

At this stage, the CPU 43 controls the detection signal input/output circuit 42 connected with the rods 62 of the respective probes 41, for example, in the A-end side wire insertion detecting jig 33 to lower the voltage levels of the rods 62 electrically connected with the A-ends of the wires one by one to the ground level. Then, the CPU 43 confirms the voltage levels of the rods 62 of the respective probes 41 in the B-end side wire insertion detecting jig 33 via the detection signal input/output circuit 42 and checks whether the voltage level of the rod 62 of the B-end side probe 41 corresponding to the wire whose voltage level is reduced from HIGH to LOW at the A-end side has properly fallen from HIGH to LOW as planned. This confirmation test is conducted at a specified time lag or period for all the wires mounted into the connector Cn.

In the case of failing the test in Step S26, the buzzer 49 is caused to repeatedly send out intermittent short buzzing sounds and the guiding LEDs 48 corresponding to the inserted positions of the A-end and B-end of the wire which has caused a failure are blinked. In such a case, the operator performs a specified repair in Step S28.

Since the mounting of the wires into the connectors Cn is properly instructed, guided and tested in the aforementioned <A-end mounting process> and <B-end mounting process>, there is no likelihood of failing to stand the test if the operations have been performed as instructed and guided. Thus, this electrical connection testing process has a meaning as a final electrical connection confirming process.

On the other hand, upon success in passing the test, the CPU 43 controls the driving circuit 46 to cause the buzzer 49 to send out a single long buzzing sound (success buzzer is rung) and the success lamp (success LED) 99 on the front surface of the control unit 34 is turned on for only 2 sec. in Step S29.

### <Connector Detaching Process>

Next, the wire-mounted and tested connectors Cn are detached from the respective wire insertion detecting jigs 33.

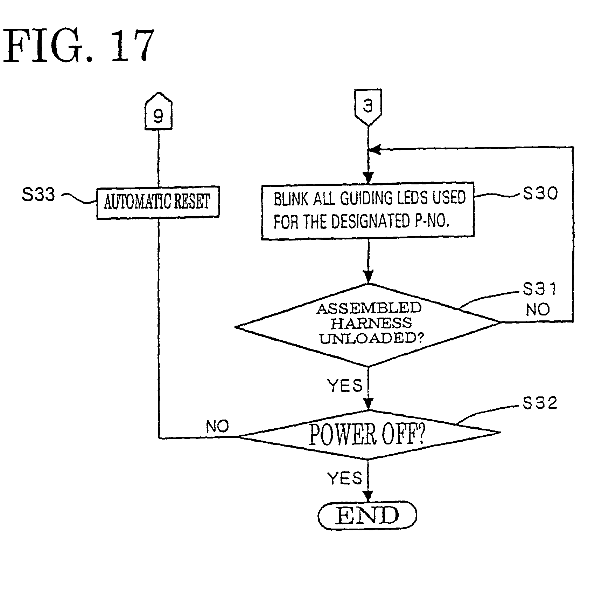

Here, all the guiding LEDs 48 of the wire insertion detecting jigs 33 used for the designated product number are blinked in Step S30 of FIG. 17. After seeing this, the operator detaches the connectors Cn from the wire insertion detecting jigs 33. Then, the ends of all the wires are detached from the probes 41, and the plungers 61 and the rods 62 (see FIG. 5A) of the probes 41 are brought into their natural states, i.e. the voltage levels thereof fall to ground level (LOW). Upon detecting it, CPU 43 then judges whether or not the main power switch 90 is off (Step S32 of FIG. 17). Unless the main power switch 90 is off, the operation routine is automatically reset (Steps S33 of FIG. 14) since there is a high possibility that the operator continues the wire mounting operation for a next subassembly. This routine returns to Step S08 of FIG. 14 to repeat the operations in Step S08 and subsequent Steps.

### <Manual Testing Process>

If manual testing is desired during the above operation, the pedal switch (not shown) connected with the pedal connecting terminal 100 of FIG. 6 is pressed, for example, for 10 sec. or longer to set the manual testing mode. The automatic testing mode and the manual testing mode are alternately switched every time the pedal switch is pressed e.g. for 10 sec. or longer. Accordingly, in the case that the operator intends to perform a specified process including the manual inserting operation, a suitable mode can be designated by an automatic/manual testing mode designating means. This function is preferably maintained even if the power is turned off.

### <Data Registering Process>

An operation procedure of the data registering process in Step S03 of FIG. 14 is described.

Data registration may be started from the A-end side or from the B-end side, but is basically divided into a process of obtaining an information on the connection between the A-end side and the B-end side and a process of saving an operation procedure for the mounting of the A-ends by successively pushing the respective probes 41 of the A-end side. Here, such a data registering method is performed, as an example, that the latter process is performed after the former process.

First, the operation mode is switched to the data registration mode by pressing the mode switch 91 provided on the front surface of the control unit 34 shown in FIG. 6 e.g. for 2 sec.

At this stage, the CPU 43 controllably drives the driving circuits 44, 45 to turn all the instructing LEDs 32 and all the guiding LEDs 48 off to notify the operator of setting of the data registration mode. Preferably, the mode switch 91 is made transparent and illuminatable by causing a light emitter at its rear surface to emit a light so that the operator is notified of setting of the data registration mode.

The data of the B-ends are inputted (extraction teaching). Specifically, the mode switch 91 is pressed e.g. for 2 sec. Then, all the instructing LEDs 32 and all the guiding LEDs 48 are turned off, and the light emitter on the rear surface of the mode switch 91 is turned on.

The operator pushes the product number switch 133 of the product number switching board 36 corresponding the product number whose data are desired to be registered. Then, the operator mounts the A-end side connector 141 and the B-end side connector 142 of the model harness as a completed subassembly as shown in FIG. 12 into the wire insertion detecting jigs 33 with which he want to correspond the connectors.

The wire mount instructing/testing apparatus detects electrical connections between the respective A-ends and the B-ends to obtain an information on the wires in the B-end side connector (teaching). The detection of the electrical connections between the A-end side and the B-end side may be carried out by a method similar to the one described under the caption <Electrical Connection Testing Process>.

Thereafter, the operator pushes the save switch provided on the front surface of the control unit 34 shown in FIG. 6, and the CPU 43 saves the registered information for the connected wires in the memory Mr.

In the data registration concerning the correspondence between the A-ends and the B-ends of the subassembly, the information can be automatically saved in the memory Mr only by pushing the save switch 96 after the model harness prepared in advance is mounted in the wire insertion detecting jigs 33. Therefore, the data can be registered by a very simple operation.

The CPU 43 then preferably automatically returns to the operation mode.

Next, the process of saving an operation procedure for the mounting of the A-ends by successively pushing the respective probes 41 in the A-end side wire insertion detecting jig is described.

First, the operator pushes the product number switch 133 of the product number switching board 36 corresponding to the product number whose data are desired to be registered. Then, the operator designates the wire desired to be mounted first while pushing the feed switch 93 provided on the front surface of the control unit 34 shown in FIG. 6. At this time, the instructing LEDs 32 are successively blinked while the feed switch 93 is pushed or every time it is pushed. The operator keeps the instructing LED 32 corresponding to the wire desired to be mounted at its blinking state while looking at the successive blinking.

The operator pulls the wire in the supplying channel 31a corresponding to the blinking instructing LED 32 out through the upper opening 31b, and inserts the A-end thereof to press it against the probe 41 in the cavity Cab of the connector Cn in the wire insertion detecting jig 33.

At this stage, the blinking instructing LED 32 is turned on and the guiding LED 48 corresponding to the probe 41 pushed by the A-end is turned on. Then, the operator pushes the save switch 96, and the CPU 43 in turn saves the registered information on the connected wire in the memory Mr.

Thereafter, the mode switch 91 is pushed again e.g. for 2 sec. to complete the data input for the A-end, and the instructing/testing apparatus returns to the operation mode. At this time, the light emitter on the rear surface of the mode switch 91 is turned off.

Correct operations are successively registered as data in the above procedure for the respective supplying channels 31 a in an order determined based on the actual operations. Accordingly, the data can be registered by a very simple method, and anybody can easily carry out data registration.

Further, since the operation procedure during the data registration is the same as the one during the actual operation (of instructing and guiding insertion), there is an advantage that the operator can easily recognize the operation procedure at the same time he carries out the data registration.

Similarly, the same operations are performed for the second and subsequent wires and, consequently, the A-ends of the all the wires used in the subassembly are connected with one connector.

If the operator tries to register an A-end which is not connected with this connector, the data registration does not proceed any further and a warning is given by the buzzer 49.

The terminals of the model harness which have not been registered as A-ends are all processed as B-ends in the control unit 34.

By employing the above method, anybody can easily register all pieces of information on the A-ends and B-ends of the subassembly in a very simple data registration procedure.

In the case of correcting the information thus registered, it may be done so by pushing the change switch 94 provided on the front surface of the control unit 34 shown in FIG. 6.

In the respective processes described above, if many wires are to be assembled and particularly all wires cannot be assembled in one wire mount instructing/testing apparatus, the number of wires to be handled can be increased by using a plurality of wire mount instructing/testing apparatuses 34A, 34B connected in series as shown in FIG. 11. In such a case, taking advantage of the function that a success signal representing successes in all test on the wire mount is outputted from the success output terminal 106 provided on the rear surface of the control unit 34, one of the two success output terminals 106 provided on the control unit 34A of one wire mount instructing/testing apparatus is connected to one connection pin 103a of the probe interface port 103 of another wire mount instructing/testing apparatus while the other is connected to the grounding terminal 108 of the other wire mount instructing/testing apparatus. An output representing the positive results in all tests conducted in the plurality of wire mount instructing/testing apparatuses can be outputted by taking a logic multiplication of the successes in all tests in the first apparatus and the successes in all tests in the second apparatus and outputting such a logic multiplication from the final wire mount instructing/testing apparatus. With such an arrangement, if the probe interface port 103 contains, for example, 60 connection pins, one of the 60 connection pins of the probe interface port 103 of the second or succeeding wire mount instructing/testing apparatus is used for the apparatus-to-apparatus connection, but the remaining 59 pins can be used for the tests.

### LIST OF REFERENCE NUMERALS

- 31: wire supplying unit
- 31a: supplying channel
- 32: instructing LED
- 33: wire insertion detecting jig
- 34: control unit
- 36: product number switching board
- 41: probe
- 43: CPU
- 44: driving circuit
- 45: driving circuit48 ... guiding LED
- 49: buzzer
- 51: jig main body
- 52: accommodating portion
- 52a: opening
- 53: through hole
- 54: base plate
- 55: barrel
- 56: metal plating
- 57: ground lead wire
- 60: through hole
- 61: plunger
- 61a: bottom end
- 62: rod
- 63: biasing member
- 64: stopper
- 65: spring bearing portion
- 66: leading end head
- 67: upper bar
- 68: lower bar
- 69: guiding tube
- 69a: flange
- 71: insulating collar
- 72: insulating collar
- 73: spring bearing portion
- 74: biasing member
- 75: contact element
- 77: connecting tube
- 78: lead wire
- 79: pull-up resistor
- 80: connecting piece
- 81: touch plate
- 84: lock
- 84a: base portion
- 84b: claw
- 84c: tapered surface
- 86: biasing member
- 90 to 96: operation switches
- 97: volume adjusting screw
- 98: tone adjusting screw
- 99: success lamp (success LED)
- 100: pedal connecting terminal
- 106: success output terminal
- 107: power supply terminal
- 111: probe detector
- 112: instructing LED controller
- 113: guiding LED controller
- 114: probe voltage switching unit
- 115: mode switching unit
- 116: wire mount guiding/testing unit
- 117: data registering unit
- 118: manual testing unit
- 119: pedal switch
- 121: A-end instructing/guiding section
- 122: B-end instructing/guiding section
- 123: electrical connection testing section
- 133: product number switch
- Cab: cavity
- Cn: connector
- Mr: memory

## Claims

1. A wire mount control apparatus for controlling the mounting of wires in a desired connector (Cn) formed with a plurality of insertion holes (Cab), comprising:
a plurality of wire supplying means (31; 31a) for supplying various wires to be supplied,
instructing indicators (32) provided in a preferably one-on-one correspondence with the plurality of wire supplying means (31; 31a) for instructing or indicating one wire supplying means (31; 31a) supplying a wire to be taken by an operator,
a plurality of wire insertion detecting jigs (33) for at least partly accommodating desired connectors (Cn) to be connected with specified wires and detecting whether or not the respective wires have been inserted into the plurality of insertion holes (Cab) of the connectors (Cn), and
a control means (34) for electrically controlling the instructing indicators (32) and the wire insertion detecting jigs (33),
wherein:
each wire insertion detecting jig (33) comprises a jig main body (51) formed with an accommodation portion (52) into which the connector (Cn) is at least partly mountable, one or more probes (41), which are preferably so provided in the accommodation portion (52) of the jig main body (51) as to substantially correspond to the respective insertion holes (Cab) of the connector (Cn), and which are held at a specified first potential when an end of the wire is not inserted in the corresponding insertion hole (Cab) while having its potential switched to a second potential different from the first potential when the end of the wire is inserted into the corresponding hole (Cab) to contact the probe (41), guiding indicators (48) provided in preferably one-on-one correspondence with the probes (41) for indicating the insertion hole (Cab) of the connector (Cn) into which the operator should mount the wire, and
the control means (34) comprises:
a first indicating section (121) for indicating one wire supplying means (31; 31a) supplying the wire the operator should take by controlling a corresponding one of the instructing indicators (32) for each of the wires in accordance with an assembling order based on a specified information preferably registered in advance in a specified storage means (Mr), indicating a proper single insertion hole (Cab) of the connector (Cn) in which the operator should mount the one end of each wire by controlling the guiding indicator (48) corresponding to the proper insertion hole (Cab),
a second indicating section (122) for detecting a wire chosen by the operator in order to mount the other end of each wire in an other connector (Cn) accommodated in an other wire insertion detecting jig (33) with the one end of each wire mounted in one connector (Cn) accommodated in the one wire insertion detecting jig (33), indicating a proper single insertion hole (Cab) of the other connector (Cn) in which the operator should mount the other end of each wire by controlling the guiding indicator (48) corresponding to the proper insertion hole (Cab) based on the detection result and a specified information preferably registered in advance in the specified storage means (Mr).

2. A wire mount control apparatus according to claim 1, wherein the wire insertion detection jig (33) comprises a touch plate or portion (81) which is exposed on the outer surface of the jig main body (51) such that the operator can intentionally bring the end of the wire into contact with the touch plate (81), and is held at the first potential.

3. A wire mount control apparatus according to claim 1, wherein the second indicating section (122) detects the wire chosen by the operator by means of the contact of the other end of each wire with the touch plate (81) based on a change in the voltage level of the probe (41) in contact with the one end of each wire from the second potential to the first potential when the operator brings the other end of each wire into contact with the touch plate (81) held at the first potential.

4. A wire mount control apparatus according to one or more of the preceding claims, wherein the first instructing section (121) is provided also for judging that the one end of each wire has been properly mounted when the voltage level of the probe (41) located at the mount position is switched from the first potential to the second potential.

5. A wire mount control apparatus according to one or more of the preceding claims, wherein the second instructing section (122) is provided also for judging that the other end of each wire has been properly mounted when the voltage level of the probe (41) located at the mount position is switched from the first potential to the second potential.

6. A wire mount control apparatus according to one or more of the preceding claims, wherein the control means (34) further comprises an electrical connection testing section (123) for testing an electrical connection between the one connector (Cn) and the other connector (Cn) through detection of potential changes in the probe (41) of the one wire insertion detecting jig (33) and the corresponding probe (41) of the other wire insertion detecting jig (33) by successively switching either the potentials of the respective probes (41) in the one wire insertion detecting jig (41) or those of the respective probes (41) in the other wire insertion detecting jig (33) from the first potential to the second potential preferably after the indication and/or the judgment are completed for all the wires in the first and second indicating sections (121, 122).

7. A wire mount controlling apparatus according to one or more of the preceding claims, further comprising a sound output means (49) for notifying a success in tests by a specified sound if the first indicating section (121) judges that the one end of each wire has been properly mounted, the second indicating section (122) judges that the other end of each wire has been properly mounted and/or the electrical connection testing section (123) detects the proper electrical connection based on an information in the storage means (Mr), while notifying a failure in tests by a specified sound if the first indicating section (121) judges that the one end of each wire has not been properly mounted, the second indicating section judges (122) that the other end of each wire has not been properly mounted and/or the electrical connection testing section (123) does not detect the proper electrical connection based on the information in the storage means (Mr).

8. A wire mount controlling apparatus according to one or more of the preceding claims, further comprising a combination selecting/designating means (36) for selecting and designating one of a plurality of combinations of the wire mount positions for each connector (Cn), wherein the controller (34) further comprises a data registering unit (117) for registering data on the plurality of combinations of the wire mount positions for each connector (Cn).

9. A wire mount controlling apparatus according to claim 8, wherein the control means (34) indicates one wire supplying means (31; 31a) supplying the wire the operator should take by controlling, preferably blinking one of the instructing indicators (32) based on the information in the storage means (Mr) if the operation of the first indicating section (121) starts with none of all the probes (41) of all the wire insertion detecting jigs (33) contacted by the wire, and controls, preferably turns on all the instructing indicators (32) corresponding to all the wire supplying means (31; 31a) supplying the wires to be mounted into the one connector (Cn) later based on the selected and designated content of the selecting/designating means (36) and/or the information in the storage means (Mr).

10. A wire mount control apparatus according to one or more of the preceding claims and claim 2, wherein the second indicating section (122) of the control means (34) judges that the other end of each wire has been properly mounted when the voltage level of the probe (41) located at the correct single insertion hole (Cab) of the other connector (Cn) is switched from the first potential to the second potential without the other end of each wire being brought into contact with the touch plate (81) by the operator.

11. A wire mount control apparatus according to one or more of the preceding claims, wherein the control means (34) is formed with at least one success output terminal (106) for outputting a success signal if all the wires have been properly mounted in the connectors (Cn) accommodated in the one and other wire insertion detecting jigs (33), and wherein the control means (34) is preferably constructed to receive a success signal sent from a success output terminal (106) of an other wire mount control apparatus and, in such a case, outputs the success signal from the success output terminal (106) thereof only when all the wires relating to this control means (34) have been properly mounted and the success signal is inputted from the other wire mount control apparatus.

12. A wire mount control apparatus according to one or more of the preceding claims, wherein the control means (34) comprises:
a function of switchingly setting a data registration mode for registering an assembling order of the respective wires and a correspondence between one ends and other ends of the respective wires based on a specified operation of the operator,
a function of, with the data registration mode set, registering sequences of the turned-on state or blinking state of the respective instructing indicators (32) and/or the respective guiding indicators (48) and a sequence of bringing the one ends of the plurality wires into contact with the respective probes (41) when the operator brings the one ends of the respective wires into contact with the respective probes (41) in the one wire insertion detecting jig (33) in a sequence employed in an actual operation while corresponding the turning-on or blinking of the respective instructing indicators (32) and/or the respective guiding indicators (48), and/or
a function of, when connectors (Cn) of a specified model harness completed beforehand by mounting opposite ends of wires in connectors (Cn) are mounted in the respective wire insertion detecting jigs (33) with the data registration mode set, extracting a correspondence in connection of the opposite ends of the respective wires mounted in the connectors (Cn) and saving it in the storage means (Mr).

13. A wire mount control method for controlling the mounting of wires in a desired connector (Cn) formed with a plurality of insertion holes (Cab), comprising the steps of:
supplying various wires to be supplied in a plurality of wire supplying means (31; 31a),
providing instructing indicators (32) in a preferably one-on-one correspondence with the plurality of wire supplying means (31; 31a) for instructing or indicating one wire supplying means (31; 31a) supplying a wire to be taken by an operator,
providing guiding indicators (48) in a preferably one-on-one correspondence with the probes (41) for indicating the insertion hole (Cab) of the connector (Cn) into which the operator should mount the wire,
at least partly accommodating desired connectors (Cn) to be connected with specified wires in a plurality of wire insertion detecting jigs (33), the wire insertion detecting jigs (33) being suitable to detect whether or not the respective wires have been inserted into the plurality of insertion holes (Cab) of the connectors (Cn), wherein, when a portion of one wire is not inserted into the respective insertion hole (Cab) of the connector (Cn), a probe (41) provided in the wire insertion detecting jig (33) in a position corresponding to the insertion hole (Cab) is held at a specified first potential while having its potential switched to a second potential different from the first potential when the end of the wire is inserted into the corresponding hole (Cab) to contact the probe (41), and
electrically controlling the instructing indicators (32) and the wire insertion detecting jigs (33) by means of a control means (34),
indicating by means of a first indicating section (121) one wire supplying means (31; 31a) supplying the wire the operator should take by controlling a corresponding one of the instructing indicators (32) for each of the wires in accordance with an assembling order based on a specified information preferably registered in advance in a specified storage means (Mr), indicating a proper single insertion hole (Cab) of the connector (Cn) in which the operator should mount the one end of each wire by controlling the guiding indicator (48) corresponding to the proper insertion hole (Cab),
detecting by means of a second indicating section (122) a wire chosen by the operator in order to mount the other end of each wire in an other connector (Cn) accommodated in an other wire insertion detecting jig (33) with the one end of each wire mounted in one connector (Cn) accommodated in the one wire insertion detecting jig (33), and
indicating a proper single insertion hole (Cab) of the other connector (Cn) in which the operator should mount the other end of each wire by controlling the guiding indicator (48) corresponding to the proper insertion hole (Cab) based on the detection result of the second indicating section (122) and a specified information preferably registered in advance in the specified storage means (Mr).

## Patentansprüche

1. Drahtmontage-Inspektions- bzw. -Steuerapparat zum Inspizieren bzw. Steuern der Montage von Drähten in einem gewünschten Verbinder (Cn), welcher mit einer Vielzahl von Einsetzlöchern (Cab) ausgebildet ist, umfassend:
eine Vielzahl von Drahtzufuhrmitteln (31; 31a) zum Zuführen von verschiedenen Drähten, welche zuzuführen sind,
instruierende bzw. Instruktionsanzeigeeinrichtungen (32), welche in einer vorzugsweise eins-zu-eins Übereinstimmung mit der Vielzahl von Drahtzufuhrmitteln (31; 31a) zum Instruieren oder Anzeigen von einem Drahtzufuhrmittel (31; 31a) vorgesehen sind, welches einen Draht zuführt, welcher durch einen Betätiger aufzunehmen ist,
eine Vielzahl von Drahteinsetz-Detektionswerkzeugen (33) für ein wenigstens teilweises Aufnehmen von gewünschten Verbindern (Cn), welche mit bestimmten Drähten zu verbinden sind, und zum Detektieren, ob die bestimmten Drähte in die Vielzahl von Einsetzlöchern (Cab) der Verbinder (Cn) eingesetzt wurden oder nicht, und
Regel- bzw. Steuermittel (34) für ein elektrisches Regeln bzw. Steuern der anweisenden bzw. instruierenden Anzeigeeinrichtungen (32) und der Drahteinsetz-Detektionswerkzeuge (33),
wobei:
jedes Drahteinsetz-Detektionswerkzeug (33) einen Betätigungselement- bzw. Werkzeug-Hauptkörper (51), welcher mit einem Aufnahmeabschnitt (52) ausgebildet ist, in welchen der Verbinder (Cn) wenigstens teilweise montierbar ist, einen oder mehrere Sensor(en) (41), welche(r) vorzugsweise so in dem Aufnahmeabschnitt (52) des Werkzeug-Hauptkörpers (51) vorgesehen ist bzw. sind, um im wesentlichen den entsprechenden Einsetzlöchern (Cab) des Verbinders (Cn) zu entsprechen, und welche(r) auf einem bestimmten ersten Potential gehalten ist bzw. sind, wenn ein Ende des Drahts nicht in das entsprechende Einsetzloch (Cab) eingesetzt ist, während ihr Potential zu einem zweiten Potential verschieden von dem ersten Potential umgeschaltet wird, wenn das Ende des Drahts in das entsprechende Loch (Cab) eingesetzt ist, um den Sensor (41) zu kontaktieren, führende bzw. Führungsindikatoren bzw. - anzeigeeinrichtungen (48) umfaßt, welche vorzugsweise in einer eins-zu-eins Übereinstimmung mit den Sensoren (41) zum Anzeigen des Einsetzlochs (Cab) des Verbinders (Cn) vorgesehen sind, in welches der Betätiger den Draht montieren soll, und
die Regel- bzw. Steuermittel (34) umfassen:
einen ersten anzeigenden bzw. Anzeigeabschnitt (121) zum Anzeigen eines Drahtzufuhrmittels (31; 31a), welches den Draht zuführt, welchen der Betätiger aufnehmen soll, indem eine entsprechende der instruierenden Anzeigeeinrichtungen (32) für jeden der Drähte in Übereinstimmung mit einer Zusammenbaureihenfolge basierend auf einer bestimmten Information geregelt bzw. gesteuert ist, welche vorzugsweise vorher in bestimmten Speichermitteln (Mr) registriert ist, Anzeigen eines ordnungsgemäßen einzigen Einsetzlochs (Cab) des Verbinders (Cn), in welches der Betätiger das eine Ende von jedem Draht montieren sollte, indem die Führungsanzeige (48) entsprechend dem ordnungsgemäßen Einsetzloch (Cab) geregelt bzw. gesteuert ist,
einen zweiten anzeigenden bzw. Anzeigeabschnitt (122) zum Detektieren eines Drahts, welcher durch den Betätiger ausgewählt ist, um das andere Ende von jedem Draht in einem anderen Verbinder (Cn) auf zu montieren, welcher in einem anderen Drahteinsetz-Detektionswerkzeug (33) aufgenommen ist, wobei das eine Ende von jedem Draht in einem Verbinder (Cn) montiert ist, welcher in dem einen Drahteinsetz-Detektionswerkzeug (33) aufgenommen ist, Anzeigen eines ordnungsgemäßen einzigen Einsetzlochs (Cab) des anderen Verbinders (Cn), in welches der Betätiger das andere Ende von jedem Draht montieren sollte, indem die Führungsanzeige (48) entsprechend dem ordnungsgemäßen Einsetzloch (Cab), basierend auf dem Detektionsresultat und einer bestimmten Information geregelt bzw. gesteuert ist, welche vorzugsweise vorab in den bestimmten Speichermitteln (Mr) registriert ist.

2. Drahtmontage-Steuerapparat nach Anspruch 1, wobei das Drahteinsetz-Detektionswerkzeug (33) eine Berührungsplatte oder einen Abschnitt (81) umfaßt, welche(r) an der äußeren Oberfläche des Werkzeug-Hauptkörpers (51) frei liegt, so daß der Betätiger bewußt das Ende des Drahts in Kontakt mit der Berührungsplatte (81) bringen kann, und auf dem ersten Potential gehalten ist.

3. Drahtmontage-Steuerapparat nach Anspruch 1, wobei der zweite anzeigende Abschnitt (122) den durch den Betätiger ausgewählten Draht mittels des Kontakts des anderen Endes von jedem Draht mit der Berührungsplatte (81) basierend auf einer Änderung in dem Spannungsniveau des Sensors (41) in Kontakt mit dem einen Ende von jedem Draht von dem zweiten Potential zu dem ersten Potential detektiert, wenn der Betätiger das andere Ende von jedem Draht in Kontakt mit der Berührungsplatte (81) bringt, welche auf dem ersten Potential gehalten ist.

4. Drahtmontage-Steuerapparat nach einem oder mehreren der vorangehenden Ansprüche, wobei der erste instruierende Abschnitt (121) auch für ein Beurteilen vorgesehen ist, daß das eine Ende von jedem Draht ordnungsgemäß montiert wurde, wenn das Spannungsniveau des Sensors (41), welcher an der Montageposition angeordnet ist, von dem ersten Potential zu dem zweiten Potential umgeschaltet ist bzw. wird.

5. Drahtmontage-Steuerapparat nach einem oder mehreren der vorangehenden Ansprüche, wobei der zweite instruierende Abschnitt (122) auch für ein Beurteilen vorgesehen ist, daß das andere Ende von jenem Draht ordnungsgemäß montiert wurde, wenn das Spannungsniveau des Sensors (41), welcher an der Montageposition angeordnet ist, von dem ersten Potential zu dem zweiten Potential umgeschaltet ist.

6. Drahtmontage-Steuerapparat nach einem oder mehreren der vorangehenden Ansprüche, wobei die Steuermittel (34) weiters einen eine elektrische Verbindung testenden Abschnitt (123) zum Testen einer elektrischen Verbindung zwischen dem einen Verbinder (Cn) und dem anderen Verbinder (Cn) durch eine Detektion von Potentialänderungen in dem Sensor (41) des einen Drahteinsetz-Detektionswerkzeugs (33) und des entsprechenden Sensors (41) des anderen Drahteinsetz-Detektionswerkzeugs (33) durch ein aufeinanderfolgendes Umschalten entweder der Potentiale der entsprechenden Sensoren (41) in dem einen Drahteinsetz-Detektionswerkzeug (41) oder derjenigen der entsprechenden Sensoren (41) in dem anderen Drahteinsetz-Detektionswerkzeug (33) von dem ersten Potential zu dem zweiten Potential umfassen, vorzugsweise nachdem die Anzeige und/oder die Beurteilung für alle Drähte in dem ersten und zweiten anzeigenden Abschnitt (121, 122) abgeschlossen ist bzw. sind.

7. Drahtmontage-Steuerapparat nach einem oder mehreren der vorangehenden Ansprüche, weiters umfassend Tonausgabemittel (49) zum Anmerken eines Erfolgs bei Tests durch einen bestimmten Ton, wenn der erste anzeigende Abschnitt (121) beurteilt, daß das erste Ende von jedem Draht ordnungsgemäß montiert wurde, der zweite anzeigende Abschnitt (122) beurteilt, daß das andere Ende von jedem Draht ordnungsgemäß montiert wurde, und/oder der eine elektrische Verbindung testende Abschnitt (123) die ordnungsgemäße elektrische Verbindung basierend auf einer Information in den Speichermitteln (Mr) detektiert, während ein Fehler bzw. Versagen in Tests durch einen bestimmten Ton angemerkt wird, wenn der erste anzeigende Abschnitt (121) beurteilt, daß das eine Ende von jenem Draht nicht ordnungsgemäß montiert wurde, der zweite anzeigende Abschnitt (122) beurteilt, daß das andere Ende von jenem Draht nicht ordnungsgemäß montiert wurde, und/oder der eine elektrische Verbindung testende Abschnitt (123) nicht die ordnungsgemäße elektrische Verbindung basierend auf der Information in den Speichermitteln (Mr) detektiert.

8. Drahtmontage-Steuerapparat nach einem oder mehreren der vorangehenden Ansprüche, weiters umfassend eine Kombination von auswählenden/bezeichnenden Mitteln (36) zum Auswählen und Bezeichnen von einer aus einer Vielzahl von Kombinationen der Drahtmontageposition für jeden Verbinder (Cn), wobei die Regel- bzw. Steuereinrichtung bzw. der Controller (34) weiters eine Datenregistriereinheit (117) zum Registrieren von Daten an der Vielzahl von Kombinationen der Drahtmontagepositionen für jeden Verbinder (Cn) umfaßt.

9. Drahtmontage-Steuerapparat nach Anspruch 8, wobei die Regel- bzw. Steuermittel (34) ein Drahtzufuhrmittel (31; 31a) anzeigen, welches den Draht zuführt, welchen den Betätiger nehmen sollte, indem eine der instruierenden Anzeigeeinrichtungen (32) basierend auf der Information in den Speichermitteln (Mr) geregelt bzw. gesteuert, vorzugsweise blinken gelassen wird, wenn der Betrieb des ersten anzeigenden Abschnitts (121) startet, wobei keiner von allen Sensoren (41) von allen Drahteinsetz-Detektionswerkzeugen (33) durch den Draht kontaktiert ist, und alle instruierenden Anzeigeeinrichtungen (32) entsprechend allen Drahtzufuhrmitteln (31; 31a) regeln bzw. steuern, insbesondere einschalten, welche die Drähte, welche in dem einen Verbinder (Cn) später zu montieren sind, basierend auf dem ausgewählten und bezeichneten Inhalt der auswählenden/bezeichnenden Mittel (36) und/oder der Information in den Speichermitteln (Mr) zuführen.

10. Drahtmontage-Steuerapparat nach einem oder mehreren der vorangehenden Ansprüche und Anspruch 2, wobei der zweite anzeigende Abschnitt (122) der Regel- bzw. Steuermittel (34) beurteilt, daß das andere Ende von jedem Draht ordnungsgemäß montiert wurde, wenn das Spannungsniveau des Sensors (41), welcher an dem korrekten einzelnen Einsetzloch (Cab) des anderen Verbinders (Cn) angeordnet ist, von dem ersten Potential zu dem zweiten Potential umgeschaltet wird, oder daß das andere Ende von jedem Draht in Kontakt mit der Berührungsplatte (81) durch den Betätiger gebracht wird.

11. Drahtmontage-Steuerapparat nach einem oder mehreren der vorangehenden Ansprüche, wobei die Regel- bzw. Steuermittel (34) mit wenigstens einem Erfolgsausgabeanschluß (106) zum Ausgeben eines Erfolgssignals ausgebildet sind, wenn alle Drähte ordnungsgemäß in den Verbindern (Cn) montiert bzw. angeordnet wurden, welche in dem einen oder anderen Drahteinsetz-Detektionswerkzeug (33) aufgenommen sind, und wobei die Regel- bzw. Steuermittel (34) vorzugsweise konstruiert sind, um ein Erfolgssignal zu erhalten, welches von einem Erfolgsausgabeanschluß (106) eines anderen Drahtmontage-Steuergeräts gesammelt wird, und in einem derartigen Fall das Erfolgssignal von dem Erfolgsausgabeanschluß (106) davon nur dann ausgibt, wenn alle Drähte, welche sich auf diese Regel- bzw. Steuermittel (34) beziehen, ordnungsgemäß montiert wurden und das Erfolgssignal von dem anderen Drahtmontage-Steuergerät eingegeben ist.

12. Drahtmontage-Steuerapparat nach einem oder mehreren der vorangehenden Ansprüche, wobei die Regel- bzw. Steuermittel (34) umfassen:
eine Funktion eines schaltenden Einstellens eines Datenregistrierungsmodus für ein Registrieren einer Zusammenbauordnung bzw. -reihenfolge der entsprechenden Drähte und einer Übereinstimmung zwischen einen Enden und
anderen Enden der entsprechenden Drähte basierend auf einem bestimmten Vorgang bzw. einer bestimmten Betätigung des Betätigers,
eine Funktion eines Registrierens, wobei der Datenregistrierungsmodus gesetzt bzw. eingestellt ist, von Sequenzen des eingeschalteten Zustands oder eines blinkenden Zustands der entsprechenden instruierenden Anzeigeeinrichtungen (32) und/oder der entsprechenden führenden Anzeigeeinrichtungen (48) und
einer Sequenz eines Bringens der einen Enden der Vielzahl von Drähten in Kontakt mit den entsprechenden Sensoren (41), wenn der Betätiger die einen Enden der entsprechenden Drähte in Kontakt mit den entsprechenden Sensoren (41) in dem einen Drahteinsetz-Detektionswerkzeug (33) in einer Sequenz bringt, welche in einem tatsächlichen Vorgang bzw. bei einer tatsächlichen Betätigung verwendet wird, während das Einschalten oder Blinken der entsprechenden instruierenden Anzeigeeinrichtungen (32) und/oder der entsprechenden führenden Anzeigeeinrichtungen (48) entspricht, und/oder
eine Funktion eines Entnehmens, wenn Verbinder (Cn) einer bestimmten Modellverkabelung, welche vorher durch ein Montieren von gegenüberliegenden Enden von Drähten in Verbindern (Cn) fertiggestellt wurde, in den entsprechenden Drahteinsetz-Detektionswerkzeugen (33) montiert bzw. angeordnet sind, wobei der Datenregistrierungsmodus eingestellt ist, einer Übereinstimmung in einer Verbindung der gegenüberliegenden Enden der entsprechenden Drähte, welche in den Verbindern (Cn) montiert sind, und eines Speicherns in den Speichermitteln (Mr).

13. Drahtmontage-Steuer- bzw. Inspektionsverfahren zum Regeln bzw. Steuern bzw. Instruieren der Montage von Drähten in einem gewünschten Verbinder (Cn), welcher mit einer Vielzahl von Einsetzlöchern (Cab) ausgebildet ist, umfassend die Schritte eines:
Zuführens von verschiedenen Drähten, welche in einer Vielzahl von Drahtzufuhrmitteln (31; 31a) zuzuführen sind,
Bereitstellens von instruierenden bzw. Instruktionsanzeigeeinrichtungen (32) in einer vorzugsweise eins-zu-eins Übereinstimmung mit der Vielzahl von Drahtzufuhrmitteln (31; 31a) zum Instruieren oder Anzeigen von einem Drahtzufuhrmittel (31; 31a), welches einen Draht zuführt, welcher von einem Betätiger aufzunehmen ist,
Bereitstellens von führenden bzw. Führungsanzeigeeinrichtungen (48) in einer vorzugsweise eins-zu-eins Übereinstimmung mit den Sensoren (41) zum Anzeigen des Einsetzlochs (Cab) des Verbinders (Cn), in welches der Betätiger den Draht montieren sollte,
wenigstens teilweisen Aufnehmens von gewünschten Verbindern (Cn), welche mit bestimmten Drähten zu verbinden sind, in einer Vielzahl von Drahteinsetz-Detektionswerkzeugen (33), wobei die Drahteinsetz-Detektionswerkzeuge (33) geeignet sind, um zu detektieren, ob die entsprechenden Drähte in die Vielzahl von Einsetzlöchern (Cab) der Verbinder (Cn) eingesetzt wurden oder nicht,
wobei, wenn ein Abschnitt von einem Draht nicht in das entsprechende Einsetzloch (Cab) des Verbinders (Cn) eingesetzt wird, ein Sensor (41), welcher in dem Drahteinsetz-Detektionswerkzeug (33) in einer Position entsprechend dem Einsetzloch (Cab) vorgesehen wird, auf einem bestimmten ersten Potential gehalten wird, während er sein Potential zu einem zweiten Potential, verschieden von dem ersten Potential umgeschaltet aufweist, wenn das Ende des Drahts in das entsprechende Loch (Cab) eingesetzt wird, um den Sensor (41) zu kontaktieren, und
elektrischen Regelns bzw. Steuerns der instruierenden Anzeigen bzw. Anzeigeeinrichtungen (32) und der Drahteinsetz-Detektionswerkzeuge (33) mittels Regel- bzw. Steuermitteln (34),
Anzeigens mittels eines ersten anzeigenden Abschnitts (121) eines Drahtzufuhrmittels (31; 31a), welches den Draht zuführt, welchen der Betätiger nehmen sollte, indem eine entsprechende der instruierenden Anzeigeeinrichtungen (32) für jeden der Drähte in Übereinstimmung mit einer Zusammenbaureihenfolge basierend auf einer bestimmten Information geregelt bzw. gesteuert wird, welche vorzugsweise vorab in bestimmten Speichermitteln (Mr) registriert wird, eines Anzeigens eines ordnungsgemäßen einzigen Einsetzlochs (Cab) des Verbinders (Cn), in welches der Betätiger das eine Ende von jedem Draht montieren sollte, durch ein Regeln bzw. Steuern der führenden Anzeigeeinrichtung (48) entsprechend dem ordnungsgemäßen Einsetzloch (Cab),
Detektierens mittels eines zweiten anzeigenden Abschnitts (122) eines Drahts, welcher durch den Betätiger ausgewählt wurde, um das andere Ende von jedem Draht in einem anderen Verbinder (Cn) zu montieren bzw. anzuordnen, welcher in einem anderen Drahteinsetz-Detektionswerkzeug (33) aufgenommen wird, wobei das eine Ende von jedem Draht in einem Verbinder (Cn) montiert wird, welcher in dem einen Drahteinsetz-Detektionswerkzeug (33) aufgenommen wird, und
Anzeigens eines ordnungsgemäßen einzigen Einsetzlochs (Cab) des anderen Verbinders (Cn), in welches der Verbinder das andere Ende von jedem Draht montieren sollte, durch ein Regeln bzw. Steuern der führenden Anzeigeeinrichtung (48) entsprechend dem ordnungsgemäßen Einsetzloch (Cab) basierend auf dem Detektionsresultat des zweiten anzeigenden Abschnitts (122) und einer bestimmten Information, welche vorzugsweise vorab in den bestimmten Speichermitteln (Mr) registriert wird.

## Revendications

1. Dispositif de contrôle de montage de fils pour contrôler le montage de fils dans un connecteur (Cn) souhaité comportant une pluralité de trous d'insertion (Cab), comprenant :
une pluralité de moyens d'alimentation en fils (31 ; 31a) pour fournir divers fils devant être fournis,
des indicateurs d'instruction (32) prévus de préférence dans une relation un à un avec la pluralité de moyens d'alimentation en fils (31 ; 31a) pour demander ou indiquer à un moyen d'alimentation en fil (31 ; 31a) de fournir un fil devant être pris par un opérateur,
une pluralité de montages de détection d'insertion de fils (33) pour recevoir au moins partiellement des connecteurs (Cn) souhaités devant être connectés à des fils spécifiés et pour détecter si les fils respectifs ont ou non été insérés dans la pluralité de trous d'insertion (Cab) des connecteurs (Cn), et
des moyens de contrôle (34) pour contrôler électriquement les indicateurs d'instruction (32) et les montages de détection d'insertion de fils (33),
dans lequel :
chaque montage de détection d'insertion de fils (33) comprend un corps principal de montage (51) comportant une partie de réception (52) dans laquelle le connecteur (Cn) peut être monté au moins partiellement, une ou plusieurs sondes (41), qui sont de préférence prévues dans la partie de réception (52) du corps principal de montage (51) de manière à sensiblement correspondre aux trous d'insertion (Cab) respectifs du connecteur (Cn), et qui sont maintenues à un premier potentiel spécifié lorsqu'une extrémité du fil n'est pas insérée dans le trou d'insertion (Cab) correspondant, tandis que leur potentiel est commuté vers un deuxième potentiel différent du premier potentiel lorsque l'extrémité du fil est insérée dans le trou (Cab) correspondant afin d'être en contact avec la sonde (41), des indicateurs de guidage (48) prévus de préférence dans une relation un à un avec les sondes (41) pour indiquer le trou d'insertion (Cab) du connecteur (Cn) dans lequel l'opérateur devrait monter le fil, et
les moyens de contrôle (34) comprennent :
une première section d'indication (121) pour indiquer un moyen d'alimentation en fil (31 ; 31a) fournissant le fil que l'opérateur devrait prendre en contrôlant un indicateur correspondant parmi les indicateurs d'instruction (32) pour chacun des fils conformément à un ordre d'assemblage basé sur une information spécifiée de préférence enregistrée à l'avance dans des moyens de mémorisation (Mr) spécifiés, indiquant un trou d'insertion (Cab) correct unique du connecteur (Cn) dans lequel l'opérateur devrait monter la première extrémité de chaque fil en contrôlant l'indicateur de guidage (48) correspondant au trou d'insertion (Cab) correct,
une deuxième section d'indication (122) pour détecter un fil choisi par l'opérateur afin de monter l'autre extrémité de chaque fil dans un autre connecteur (Cn) reçu dans un autre montage de détection d'insertion de fils (33), la première extrémité de chaque fil étant montée dans un connecteur (Cn) reçu dans le premier montage de détection d'insertion de fils (33), indiquant un trou d'insertion (Cab) correct de l'autre connecteur (Cn) dans lequel l'opérateur devrait monter l'autre extrémité de chaque fil en contrôlant l'indicateur de guidage (48) correspondant au trou d'insertion (Cab) correct sur la base du résultat de détection et d'une information spécifiée de préférence enregistrée à l'avance dans les moyens de mémorisation (Mr) spécifiés.

2. Dispositif de contrôle de montage de fils selon la revendication 1, dans lequel le montage de détection d'insertion de fils (33) comprend une plaque ou partie de contact (81) qui est exposée sur la surface extérieure du corps principal de montage (51) de telle sorte que l'opérateur puisse intentionnellement amener l'extrémité du fil en contact avec la plaque de contact (81) et qui est maintenue au premier potentiel.

3. Dispositif de contrôle de montage de fils selon la revendication 1, dans lequel la deuxième section d'indication (122) détecte le fil choisi par l'opérateur au moyen du contact de l'autre extrémité de chaque fil avec la plaque de contact (81) sur la base d'un passage du niveau de tension de la sonde (41) en contact avec la première extrémité de chaque fil du deuxième potentiel au premier potentiel lorsque l'opérateur amène l'autre extrémité de chaque fil en contact avec la plaque de contact (81) maintenue au premier potentiel.

4. Dispositif de contrôle de montage de fils selon une ou plusieurs des revendications précédentes, dans lequel la première section d'instruction (121) est prévue également pour juger que la première extrémité de chaque fil a été correctement montée lorsque le niveau de tension de la sonde (41) située à la position de montage passe du premier potentiel au deuxième potentiel.

5. Dispositif de contrôle de montage de fils selon une ou plusieurs des revendications précédentes, dans lequel la deuxième section d'instruction (122) est également prévue pour juger que l'autre extrémité de chaque fil a été correctement montée lorsque le niveau de tension de la sonde (41) située à la position de montage passe du premier potentiel au deuxième potentiel.

6. Dispositif de contrôle de montage de fils selon une ou plusieurs des revendications précédentes, dans lequel les moyens de contrôle (34) comprennent en outre une section de test de connexion électrique (123) pour tester une connexion électrique entre le premier connecteur (Cn) et l'autre connecteur (Cn) par la détection de changements de potentiel dans la sonde (41) du premier montage de détection d'insertion de fils (33) et dans la sonde (41) correspondante de l'autre montage de détection d'insertion de fils (33) en faisant passer successivement soit les potentiels des sondes (41) respectives dans le premier montage de détection d'insertion de fils (33), soit ceux des sondes (41) respectives dans l'autre montage de détection d'insertion de fils (33) du premier potentiel au deuxième potentiel, de préférence une fois que l'indication et/ou le jugement sont achevés pour tous les fils dans les première et deuxième sections d'indication (121, 122).

7. Dispositif de contrôle de montage de fils selon une ou plusieurs des revendications précédentes, comprenant en outre des moyens de sortie de son (49) pour indiquer un succès des tests par un son spécifié si la première section d'indication (121) juge que la première extrémité de chaque fil a été correctement montée, si la deuxième section d'indication (122) juge que l'autre extrémité de chaque fil a été correctement montée et/ou si la section de test de connexion électrique (123) détecte la connexion électrique correcte sur la base d'une information dans les moyens de mémorisation (Mr), et pour indiquer un échec des tests par un son spécifié si la première section d'indication (121) juge que la première extrémité de chaque fil n'a pas été correctement montée, si la deuxième section d'indication (122) juge que l'autre extrémité de chaque fil n'a pas été correctement montée et/ou si la section de test de connexion électrique (123) ne détecte pas la connexion électrique correcte sur la base de l'information dans les moyens de mémorisation (Mr).

8. Dispositif de contrôle de montage de fils selon une ou plusieurs des revendications précédentes, comprenant en outre des moyens de sélection/désignation de combinaison (36) pour sélectionner et désigner l'une d'une pluralité de combinaisons des positions de montage de fils pour chaque connecteur (Cn), dans lequel le contrôleur (34) comprend en outre une unité d'enregistrement de données (117) pour enregistrer des données concernant la pluralité de combinaisons des positions de montage de fils pour chaque connecteur (Cn).

9. Dispositif de contrôle de montage de fils selon la revendication 8, dans lequel les moyens de contrôle (34) indiquent un moyen d'alimentation en fil (31 ; 31a) fournissant le fil que l'opérateur devrait prendre en contrôlant, de préférence en faisant clignoter un des indicateurs d'instruction (32) sur la base de l'information contenue dans les moyens de mémorisation (Mr) si le fonctionnement de la première section d'indication (121) commence alors qu'aucune des sondes (41) de tous les montages de détection d'insertion de fils (33) n'est en contact avec le fil, et contrôlent, de préférence activent tous les indicateurs d'instruction (32) correspondant à tous les moyens d'alimentation en fils (31 ; 31a) fournissant les fils devant être montés dans le premier connecteur (Cn) ultérieurement sur la base du contenu sélectionné et désigné des moyens de sélection/désignation (36) et/ou de l'information contenue dans les moyens de mémorisation (Mr).

10. Dispositif de contrôle de montage de fils selon une ou plusieurs des revendications précédentes, et la revendication 2, dans lequel la deuxième section d'indication (122) des moyens de contrôle (34) juge que l'autre extrémité de chaque fil a été correctement montée lorsque le niveau de tension de la sonde (41) située au niveau du trou d'insertion (Cab) unique correct de l'autre connecteur (Cn) est passé du premier potentiel au deuxième potentiel sans que l'autre extrémité de chaque fil ne soit amenée en contact avec la plaque de contact (81) par l'opérateur.

11. Dispositif de contrôle de montage de fils selon une ou plusieurs des revendications précédentes, dans lequel les moyens de contrôle (34) comportent au moins une borne de sortie de succès (106) pour sortir un signal de succès si tous les fils ont été correctement montés dans les connecteurs (Cn) reçus dans l'un et l'autre des montages de détection d'insertion de fils (33), et dans lequel les moyens de contrôle (34) sont de préférence réalisés pour recevoir un signal de succès envoyé à partir d'une borne de sortie de succès (106) d'un autre dispositif de contrôle de montage de fils et, dans un tel cas, délivrent le signal de succès à partir de leur borne de sortie de succès (106) uniquement lorsque tous les fils concernant ces moyens de contrôle (34) ont été correctement montés et que le signal de succès est appliqué par l'autre dispositif de contrôle de montage de fils.

12. Dispositif de contrôle de montage de fils selon une ou plusieurs des revendications précédentes, dans lequel les moyens de contrôle (34) comprennent :
une fonction de détermination par commutation d'un mode d'enregistrement de données pour enregistrer un ordre d'assemblage des fils respectifs et une correspondance entre des premières extrémités et d'autres extrémités des fils respectifs sur la base d'une opération spécifiée de l'opérateur,
une fonction, le mode d'enregistrement étant déterminé, d'enregistrement de séquences de l'état activé ou de l'état clignotant des indicateurs d'instruction (32) respectifs et/ou des indicateurs de guidage (48) respectifs et d'une séquence de mise en contact des premières extrémités de la pluralité de fils avec les sondes (41) respectives lorsque l'opérateur amène les premières extrémités des fils respectifs en contact avec les sondes (41) respectives dans le premier montage de détection d'insertion de fils (33) dans une séquence utilisée dans un fonctionnement réel tout en correspondant à l'activation ou au clignotement des indicateurs d'instruction (32) respectifs et/ou des indicateurs de guidage (48) respectifs, et/ou
une fonction, lorsque des connecteurs (Cn) d'un faisceau d'un modèle spécifié achevé au préalable en montant des extrémités opposées de fils dans des connecteurs (Cn) sont montés dans les montages de détection d'insertion de fils (33) respectifs, le mode d'enregistrement de données étant déterminé, d'extraction d'une correspondance en relation avec les extrémités opposées des fils respectifs montés dans les connecteurs (Cn) et de sauvegarde de celle-ci dans les moyens de mémorisation (Mr).

13. Procédé de contrôle de montage de fils pour contrôler le montage de fils dans un connecteur (Cn) souhaité comportant une pluralité de trous d'insertion (Cab), comprenant les étapes consistant à :
fournir divers fils devant être fournis dans une pluralité de moyens d'alimentation en fils (31 ; 31a),
prévoir des indicateurs d'instruction (32) de préférence dans une relation un à un avec la pluralité de moyens d'alimentation en fils (31 ; 31a) pour demander ou indiquer à un moyen d'alimentation en fil (31 ; 31a) de fournir un fil devant être pris par un opérateur,
prévoir des indicateurs de guidage (48) de préférence dans une relation un à un avec les sondes (41) pour indiquer le trou d'insertion (Cab) du connecteur (Cn) dans lequel l'opérateur devrait monter le fil,
recevoir au moins partiellement des connecteurs (Cn) souhaités devant être connectés à des fils spécifiés dans une pluralité de montage de détection d'insertion de fils (33), les montages de détection d'insertion de fils (33) étant adaptés pour détecter si les fils respectifs ont ou non été insérés dans la pluralité de trous d'insertion (Cab) des connecteurs (Cn), dans lequel, lorsqu'une partie d'un fil n'est pas insérée dans le trou d'insertion (Cab) respectif du connecteur (Cn), une sonde (41) prévue dans le montage de détection d'insertion de fils (33) à une position correspondant au trou d'insertion (Cab) est maintenue à un premier potentiel spécifié, tandis que son potentiel est passé à un deuxième potentiel différent du premier potentiel lorsque l'extrémité du fil est insérée dans le trou (Cab) correspondant pour être en contact avec la sonde (41), et
contrôler électriquement les indicateurs d'instruction (32) et les montages de détection d'insertion de fils (33) à l'aide de moyens de contrôle (34),
indiquer, au moyen d'une première section d'indication (121), un moyen d'alimentation en fil (31 ; 31a) fournissant le fil que l'opérateur devrait prendre en contrôlant un indicateur correspondant parmi les indicateurs d'instruction (32) pour chacun des fils conformément à un ordre d'assemblage basé sur une information spécifiée de préférence enregistrée à l'avance dans des moyens de mémorisation (Mr) spécifiés, indiquant un trou d'insertion (Cab) unique correct du connecteur (Cn) dans lequel l'opérateur devrait monter la première extrémité de chaque fil en contrôlant l'indicateur de guidage (48) correspondant au trou d'insertion (Cab) correct,
détecter, au moyen d'une deuxième section d'indication (122), un fil choisi par l'opérateur afin de monter l'autre extrémité de chaque fil dans un autre connecteur (Cn) reçu dans un autre montage de détection d'insertion de fils (33), la première extrémité de chaque fil étant montée dans un connecteur (Cn) reçu dans le premier montage de détection d'insertion de fils (33), et
indiquer un trou d'insertion (Cab) unique correct de l'autre connecteur (Cn) dans lequel l'opérateur devrait monter l'autre extrémité de chaque fil en contrôlant l'indicateur de guidage (48) correspondant au trou d'insertion (Cab) correct sur la base du résultat de détection de la deuxième section d'indication (122) et d'une information spécifiée de préférence enregistrée à l'avance dans les moyens de mémorisation (Mr) spécifiés.
